# EUROPEAN PATENT APPLICATION

(11) **EP 1 254 926 A1**
(43) Date of publication of application: **06.11.2002**
(21) Application number: 01951946.1
(22) Date of filing: 19.07.2001
(51) Int. Cl.: C08L 101/00, C08K 3/00, C08L 63/00, H01L 23/14, H05K 3/46

(54) **INSULATING RESIN COMPOSITION FOR MULTILAYER PRINTED WIRING BOARDS, MULTILAYER PRINTED WIRING BOARDS MADE BY USING THE COMPOSITION AND PROCESS FOR THE PRODUCTION THEREOF**

(30) Priority: 21.07.2000 JP 2000221200; 13.06.2001 JP 2001179083
(71) Applicant: Toppan Printing Co., Ltd., Taito-ku, Tokyo 110-0016 (JP); Sumitomo Chemical Company, Limited, Osaka-shi Osaka 541-8550 (JP)
(72) Inventor: KOMOTO, Kenji, c/o TOPPAN PRINTING CO., LTD., Tokyo 110-0016 (JP); TONEGAWA, Masahisa, c/o TOPPAN PRINTING CO., LTD., Tokyo 110-0016 (JP); MURATA, Koji, c/o TOPPAN PRINTING CO., LTD., Tokyo 110-0016 (JP); CHINO, Masaaki, c/o TOPPAN PRINTING CO., LTD., Tokyo 110-0016 (JP); MURAI, Toshie, c/o TOPPAN PRINTING CO., LTD., Tokyo 110-0016 (JP); HAYASHI, Toshiaki, Tsukuba-shi, Ibaraki 305-0035 (JP); SAITO, Noriaki, Toyonaka-shi, Osaka 560-0874 (JP); OKAMOTO, Satoshi, Tsukuba-shi, Ibaraki 305-0045 (JP)
(74) Representative: Leson, Thomas Johannes Alois, Dipl.-Ing.
(86) International application number: JP0106292
(87) International publication number: WO02008338

(57) **Abstract**

Disclosed is a resin composition comprising a thermosetting resin, a thermoplastic resin and a filler. The cured resin of the resin composition has a fine phase separated structure, and the filler is distributed in one of the thermosetting resin rich phase and the thermoplastic resin rich phase. The resin composition of the present invention permits obtaining an insulating layer, which has a high resistance to heat, has a high toughness, is small in thermal deformation, exhibits a high bonding strength with a copper wiring, and permits forming a fine pattern.

## Description

### Technical Field

The present invention relates to a multi-layered printed circuit wiring board used in, for example, a semiconductor package and to a method of manufacturing the same, particularly, to an insulating resin composition used for forming an interlayer insulating film of the multi-layered printed circuit wiring board and to the manufacture of an insulating film using the particular resin composition.

### Background Art

In recent years, miniaturization and high speed operation of an electronic equipment are being promoted in accordance with progress in the field of electronics. In this connection, improvements in density and reliability by fine pattern are required in the package in which an IC or an LSI is directly mounted.

In the conventional package in which an LSI or the like is mounted, a problem is brought about that cracks are generated in the bonding boundary between the LSI and the mounting substrate (interposer) because of the difference in the thermal expansion coefficient between the LSI and the interposer so as to render the electrical reliability insufficient.

Such being the situation, a silica filler was added to the interposer so as to decrease the thermal expansion coefficient of the interposer in an attempt to decrease the difference in the thermal expansion coefficient between the mounting article and the substrate to which the mounting article is mounted.

Also, another problem is brought about that cracks are generated in the interposer itself by the severe durability test and, thus, it was desirable to improve the toughness of the insulating material used in the mounting substrate.

In recent years, developed was a technology for imparting a toughness to a resin by mixing a thermoplastic resin such as a polyether sulfone with an epoxy resin as an improvement of the epoxy resin used as such an insulating material as a thermosetting resin, as described in "Keizo Yamanaka and Takashi Inoue, Polymer, Vol. 30, P662 (1989)". The polyether sulfone alloyed epoxy resin formed by mixing two kinds of resins exhibits a toughness of resin higher than that of the resin formed of the epoxy resin alone. The reason for the improved toughness of the polyether sulfone modified epoxy resin is that the alloyed epoxy resin forms a phase separated structure consisting of an epoxy rich phase having the epoxy resin as a main component and a polyether sulfone rich phase containing polyether sulfone as a main component and it behaves to be joined to each other and in a regularly dispersed state.

The resin substrate using a thermosetting resin represented by the epoxy resin for forming an insulating layer is lightweight and cheap and, thus, has come to be used not only as a high density printed circuit wiring board but also as a substrate for mounting a semiconductor bare chip. However, the required miniaturization of the conductor pattern tends to further proceed. In this case, how to ensure the bonding strength is a serious problem to be solved. If the irregularity of the surface anchor is increased in an attempt to solve this problem, the uniformity and the reliability of a fine-line wiring pattern are impaired, giving rise to the problem that the improvement in both the fine-line and the bonding strength cannot be satisfied simultaneously.

In order to impart effectively a toughness to the brittle thermoset epoxy resin, it is necessary for the thermosetting resin and the thermoplastic resin to form a phase separated structure after the thermosetting treatment. Where the thermoplastic resin and the thermosetting resin are uniformly mixed to have seemingly a structure close to a miscible structure, the coarsened surface is finely coarsened in the surface coarsening process in the copper plating step and, thus, is advantageous for forming the fine-line. However, the polymer alloy formed between the thermosetting resin and the thermoplastic resin fails to exhibit sufficiently a high toughness inherent in the polymer alloy, though the polymer alloy exhibits a certain improvement in toughness. It should also be noted that the thermoplastic resin component having a relatively weak bonding strength with the copper plating is finely dispersed, with the result that the bonding strength between the insulating layer and the copper pattern is lowered. On the other hand, where the phase separation structure is rough, the copper plating strength is certainly improved. However, the coarsened surface layer is rendered excessively coarse so as to obstruct the formation of a fine wiring pattern. In other words, it is impossible to form an insulating layer satisfying all of the requirements including the toughness, the plating strength, the bonding strength, and formation of a fine wiring pattern.

A first object of the present invention is to provide an insulating resin composition for a multi-layered printed circuit wiring board, which exhibits a high resistance to heat, has a high toughness, is small in thermal expansion coefficient, is satisfactory in the bonding properties to the copper wiring, and has a finely coarsened surface adapted for forming a fine pattern.

A second object of the present invention is to provide a multi-layered printed circuit wiring board having a high reliability, which exhibits a high resistance to heat, has a high toughness, is small in thermal expansion coefficient, is satisfactory in the bonding properties to the copper wiring, and has a finely coarsened surface adapted for forming a fine pattern.

A third object of the present invention is to provide a method of manufacturing a multi-layered printed circuit wiring board, which permits manufacturing easily and with a low cost a multi-layered printed circuit wiring board having a high reliability, which exhibits a high resistance to heat, has a high toughness, is small in thermal expansion coefficient, is satisfactory in the bonding properties to the copper wiring, and has a finely coarsened surface adapted for forming a fine pattern.

According to a fourth object of the present invention is to provide a transfer sheet of an insulating resin layer for a multi-layered printed circuit wiring board capable of forming an insulating layer, which exhibits a high resistance to heat, has a high toughness, is small in thermal expansion coefficient, is satisfactory in the bonding properties to the copper wiring, and has a finely coarsened surface adapted for forming a fine pattern.

### Disclosure of Invention

According to a first aspect of the present invention, there is provided an insulating resin composition for a multi-layered printed circuit wiring board, comprising:
i) a thermoplastic resin;
ii) a first thermosetting resin capable of forming a resin composite having a phase separated structure when a mixture of the first thermosetting resin and the thermoplastic resin is cured, and
iii) a filler,
wherein a cured resin of the insulating resin composition has a fine phase separated structure, and the filler is distributed in one of the thermosetting resin rich phase and the thermoplastic resin rich phase.

According to a second aspect of the present invention, there is provided a multi-layered printed circuit wiring board, comprising:
a substrate having a first wiring pattern;
an insulating layer formed on the substrate; and
a second wiring pattern formed on the insulating layer in a manner to be electrically connected to the first wiring pattern;
wherein the insulating layer includes:
i) a thermoplastic resin;
ii) a first thermosetting resin capable of forming a resin composite having a phase separated structure when a mixture of the first thermosetting resin and the thermoplastic resin is cured, and
iii) a filler, wherein the cured resin of the insulating resin composition has a fine phase separated structure, and the filler is distributed in one of the thermosetting resin rich phase and the thermoplastic resin rich phase.

According to a third aspect of the present invention, there is provided a method of manufacturing a multi-layered printed circuit wiring board, comprising the steps of:
forming an insulating layer having a fine phase separated structure by preparing a resin composition comprising:
   i) a thermoplastic resin;
   ii) a first thermosetting resin capable of forming a resin composite having a phase separated structure when a mixture of the first thermosetting resin and the thermoplastic resin is cured, and
   iii) a filler, wherein a cured resin of the resin composition has a fine phase separated structure, and the filler is distributed in one of the thermosetting resin rich phase and the thermoplastic resin rich phase, followed by coating a substrate having a first wiring pattern formed thereon with the resin composition and subsequently thermally curing the coated layer of the insulating resin under a heated condition in which a phase separation is generated; and
forming a second wiring pattern on the insulating layer in a manner to be electrically connected to the first wiring pattern.

Further, according to a fourth aspect of the present invention, there is provided a transfer sheet of an insulating resin layer for a multi-layered printed circuit wiring board, comprising:
a sheet-like supporting member; and
a dry film formed on the sheet-like supporting member by using an insulating resin composition for a multi-layered printed circuit wiring board, comprising:
   i) a thermoplastic resin;
   ii) a first thermosetting resin capable of forming a resin composite having a phase separated structure when a mixture of the first thermosetting resin and the thermoplastic resin is cured, and
   iii) a filler,
wherein the cured resin of the insulating resin composition has a fine phase separated structure, and the filler is distributed in one of the thermosetting resin rich phase and the thermoplastic resin rich phase.

### Brief Description of Drawings

FIG. 1 shows as a model a sea-island structure;
FIG. 2 shows as a model a connected-globule structure;
FIG. 3 shows as a model a composite dispersion phase structure;
FIG. 4 shows as a model a co-continuous phase structure;
FIG. 5 is a photo showing as an example the surface structure of an insulating resin film;
FIG. 6 is a photo showing as another example the surface structure of an insulating resin film;
FIG. 7 is a cross sectional view showing as an example the construction of a transfer sheet of the present invention;
FIG. 8 is a cross sectional view showing as another example the construction of a transfer sheet of the present invention;
FIGS. 9A to 9G are cross sectional views collectively exemplifying a method of the present invention for manufacturing a multi-layered-printed circuit wiring board; and
FIG. 10 is a block diagram for exemplifying a method of the present invention for manufacturing a multi-layered printed circuit wiring board.

### Best Mode for Carrying Out of the Invention

The present invention provides an insulating resin composition for a multi-layered printed circuit wiring board, comprising:
i) a thermoplastic resin;
ii) a first thermosetting resin capable of forming a resin composite having a phase separated structure when a mixture of the first thermosetting resin and the thermoplastic resin is cured, and
iii) a filler,
wherein a cured resin of the insulating resin composition has a fine phase separated structure, and the filler is unevenly distributed in one of the thermosetting resin rich phase and the thermoplastic resin rich phase.

According to a preferred embodiment of the present invention, the insulating resin composition for a multi-layered printed circuit wiring board further comprises iv) a second thermosetting resin capable of forming a resin composite having a miscible structure when a mixture between the second thermosetting resin and the thermoplastic resin is cured.

The insulating resin composition for a multi-layered printed circuit wiring board according to the preferred embodiment of the present invention, comprising:
i) a thermoplastic resin;
ii) a first thermosetting resin capable of forming a resin composite having a phase separated structure when a mixture of the first thermosetting resin and the thermoplastic resin is cured, and
iii) a filler; and
iv) a second thermosetting resin capable of forming a resin composite having a miscible structure when a mixture between the second thermosetting resin and the thermoplastic resin is cured,
wherein a cured resin of the insulating resin composition has a fine phase separated structure, and the filler is distributed in one of the thermosetting resin rich phase and the thermoplastic resin rich phase.

The present invention also provides a multi-layered printed circuit wiring board formed by using the insulating resin composition described above, the multi-layered printed circuit wiring board comprising:
a substrate having a first wiring pattern;
an insulating layer formed on the substrate by using the resin composition and having a fine phase-separation structure, wherein a filler is distributed in one of the thermosetting resin rich phase and the thermoplastic resin rich phase in the fine phase-separation structure; and
a second wiring pattern formed on the insulating layer in a manner to be electrically connected to the first wiring layer.

The present invention also provides a method of manufacturing a multi-layered printed circuit wiring board, in which an insulating layer is formed by using the insulating resin composition described above, comprising the steps of:
coating a substrate having a first wiring pattern formed thereon with the insulating resin composition noted above, followed by thermally curing the resultant heat insulating resin coated layer under a heating condition in which a phase separation takes place, thereby forming an insulating layer having a fine phase separation structure; and
forming a second wiring pattern on the insulating layer in a manner to be electrically connected to the first wiring pattern.

An insulating resin transfer sheet for a multi-layered printed circuit of the present invention comprises a dry film formed by coating a sheet like supporting member with the insulating resin composition described above, followed by drying the coated insulating resin composition.

According to the present invention, an insulating layer is obtained by curing an insulating resin composition for a multi-layered printed circuit wiring board comprising at least a thermoplastic resin, a first thermosetting resin, and a filler. After the curing, the insulating layer is separated into a thermosetting resin rich phase and a thermoplastic resin rich phase so as to form a fine phase-separation structure. In addition, since the filler is selectively distributed in the thermosetting resin rich phase or the thermoplastic resin rich phase so as to satisfy simultaneously the required toughness of the insulating layer, the required bonding strength between the insulating layer and a copper wiring, and the formation of fine wiring pattern. What should also be noted is that the insulating layer obtained by using the resin composition of the present invention is highly resistant to heat and is low in thermal deformation. It follows that the present invention provides a multi-layered printed circuit wiring board having a high reliability and capable of being manufactured easily with a low cost.

According to a preferred embodiment of the present invention, a second thermosetting resin capable of forming a resin composite having a miscible structure when a mixture of the second thermosetting resin and the thermoplastic resin is cured is added to the insulating resin composition for the multi-layered printed circuit wiring board described above. Particularly, the presence of the second thermosetting resin permits further diminishing the average periodic distance in the fine phase separation structure.

It is desirable for the thermoplastic resin used as component (i) of the insulating resin composition of the present invention to be selected from the engineering plastic materials consisting of polyether sulfone, polysulfone, and polyphenylene sulfide in view of the resistance to heat. It is particularly desirable for polyether sulfone, which is excellent in various properties such as the dynamic characteristics, the insulating properties, and the solubility in a solvent, to be used as the thermoplastic resin constituting component (i) of the insulating resin composition of the present invention.

In the present invention, it is possible to use various known materials as the polysulfone. As one of examples, polysulfone can be synthesized by the desalting condensation between bisphenol A and 4,4'-dichlorophenyl sulfone, though the synthesizing method is not limited to the example. Also, these polysulfones are commercially available under the trade names of Yudel (manufactured by Amoco Inc.) and Ultrason (manufactured by BASF Inc.).

In the present invention, it is possible to use various known polyphenylene sulfides. As one of examples, the polyphenylene sulfide used in the present invention can be synthesized by the polycondensation between sodium sulfide and 4,4'-dichlorophenyl sulfone, though the synthetic method of the polyphenylene sulfide is not limited to the example. Also, these polyphenylene sulfides are available commercially under the trade names of Toprene (manufactured by Tonen Chemical Inc.) and PPS (manufactured by Idemitsu Petrochemical Co., Ltd.).

In the present invention, it is possible to use various known polyether sulfones. The terminal group of the polyether sulfone includes, for example, a chlorine atom, an alkoxy group and a phenolic hydroxyl group. Particularly, it is desirable for the terminal group of the polyether sulfone to consist of a phenolic hydroxyl group because, in this case, the affinity with the epoxy resin is improved so as to increase the mutual function performed at the interface between the polyether sulfone rich phase and the epoxy resin rich phase, thereby improving the mechanical characteristics.

It is desirable for the molecular weight of the polyether sulfone resin to fall within a range of between 1,000 and 100,000. The polyether sulfone resin having a molecular weight lower than 1,000 fails to exhibit a sufficient toughness expected for the polyether sulfone, tends to be brittle, is unlikely to form a phase separation structure with the epoxy resin, and tends to fail to impart a high toughness to the insulating resin composition. On the other hand, the polyether sulfone having a molecular weight higher than 100,000 has tendency which is unlikely to be dissolved in a solvent so as to make it difficult to handle the polyether sulfone. Also, when the polyether sulfone having a molecular weight higher than 100,000 is mixed with an epoxy resin, the mixture tends to form a phase separation structure having a co-continuous phase having a relatively large pitch, which is disadvantageous for forming a fine wiring pattern.

Also, in order to obtain sufficient characteristics in an acceleration test of an insulation reliability such as Pressure Cooker Bias Test (PCBT), it is desirable for the polyether sulfone to have an alkali metal ion concentration not higher than 500 ppm, preferably not higher than 200 ppm, and most preferably not higher than 100 ppm.

The insulating resin composition of the present invention comprises a first thermosetting resin as component (ii). When a mixture of the first thermosetting resin and the thermoplastic resin used together with the first thermosetting resin is cured, the cured material is required to have a phase separation structure. The first thermosetting resin meeting the particular requirement includes, for example, an epoxy resin, cyanate resins, bismaleimides, an addition polymer between bismaleimides and diamine, a phenolic resin, a resol resin, isocyanate, triallyl isocyanate, triallyl cyanurate and a polyolefin compound having a vinyl group, though the first thermosetting resin used in the present invention is not limited to the materials exemplified above. Particularly, it is desirable to use an epoxy resin as the first thermosetting resin in view of the balance of the properties such as the resistance to heat and the insulating properties.

Known epoxy resins can be used in the present invention including, for example, such as a phenol-novolak type epoxy resin, a cresol-novolak type epoxy resin, a bisphenol A type epoxy resin, a bisphenol F type epoxy resin, a bisphenol S type epoxy resin, a biphenyl type epoxy resin, a biphenyl-novolak type epoxy resin, a tris (hydroxyphenyl) methane type epoxy resin, a tetraphenyl ethane type epoxy resin and hydrogenated compounds of an epoxy compound having an aromatic ring such as a dicyclopentadiene phenol type epoxy resin; various derivatives of the hydrogenated compounds noted above such as an alicyclic epoxy resin and cyclohexene oxide; a halogen-containing epoxy resin such as a tetrabromobisphenol A type epoxy resin. These epoxy resins can be used singly or in the form of a mixture thereof.

Particularly, it is desirable to add the epoxy resin having chemical structure (1) given below as the first thermosetting resin because the particular epoxy resin is excellent in the resistance to heat and in the surface coarsening properties in the copper plating step:

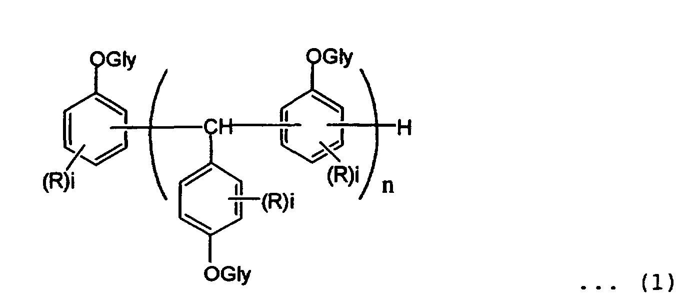

The insulating resin composition according to a preferred embodiment of the present invention comprises a second thermosetting resin as component (iv). When a mixture of the second thermosetting resin and the thermoplastic resin used together with the second thermosetting resin is cured, the cured material is required to exhibit a miscible structure. The second thermosetting resin meeting the particular requirement includes, for example, an epoxy resin, cyanate resins, bismaleimides, an addition polymer between bismaleimides and diamine, a phenolic resin, a resol resin, isocyanate, triallyl isocyanate, triallyl cyanurate and a polyolefin compound having a vinyl group. Particularly, it is desirable to use an epoxy resin as the second thermosetting resin in view of the balance of the properties such as the resistance to heat and the insulating properties.

Known epoxy resins can be used as the second thermosetting resin as far as a mixture of the epoxy resin and the thermoplastic resin used together with the second epoxy resin, which is thermally cured under certain curing conditions, is capable of forming a miscible structure. The epoxy resins meeting the particular requirement include, for example, bisphenol A type epoxy resin (trade name Epikote 828EL manufactured by Yuka shell Epoxy K.K.), a bisphenol F type epoxy resin, cresol-novolak type epoxy resin (trade name EOCN-103S manufactured by Nippon Kayaku Inc.), and glycidyl amine type epoxy resin (trade name Araldite MY721 manufactured by Asahi Ciba Inc.). These epoxy resins can be used singly or in the form of a mixture thereof.

Concerning the mixing ratio of the epoxy resin according to the first and second thermosetting resin to the polyether sulfone used in the insulating resin composition of the present invention, it is desirable for the content of the polyether sulfone to fall within a range of between 10% by weight and 40% by weight based on the total solid components of the resins. If the content of the polyether sulfone is less than 10% by weight based on the total solid components of the resins, it is difficult to obtain a sufficient effect of improving the toughness of the polyether sulfone. On the other hand, if the content of the polyether sulfone exceeds 40% by weight, it is difficult to obtain a sufficient effect of improving the bonding strength with copper.

In a preferred embodiment of the present invention, it is desirable for the weight ratio of the epoxy resin used as the first thermosetting resin to the epoxy resin used as the second thermosetting resin to fall within a range of between 95 : 5 and 50 : 50. If the mixing ratio of the second thermosetting resin to 95 of the first thermosetting resin is lower than 5, the first separation structure of the cured resin is unlikely to be fine. On the other hand, if the ratio is higher than 50 : 50, the cured resin has a structure close to the miscible structure, with the result that the strong toughness of the thermoplastic resin tends to fail to be exhibited sufficiently.

In general, the phase structure of the resin cured resin is fixed by the competitive reaction between the phase separation rate and the crosslinking reaction rate. For example, in the case of the epoxy resin, it is possible to form a fine phase separation structure having a pitch size of about 0.1 to 5 µm by mixing epoxy resins differing from each other in the characteristics by controlling the catalyst species, the skeletal structure, etc. so as to cure simultaneously the different epoxy resins.

In a preferred embodiment of the present invention, the combination of the first thermosetting resin and the second thermosetting resin is determined appropriately in view of the kinds of the thermosetting resins used, the curing conditions, the curing agent, and the curing catalyst. In other words, it is possible to select freely the combination that permits the pitch size of a periodic distance of the cured resin to fall within a range of between about 0.1 µm and about 5 µm preferably a range between about 0.1 µm and about 3 µm.

In the case of using an epoxy resin as the thermosetting resin of the present invention, it is possible to use known epoxy resin curing agents including, for example, polyhydric phenols such as a phenol novolak; amine series curing agents such as dicyandiamide, diamino diphenyl methane, and diamino diphenyl sulfone; acid anhydride curing agents such as pyromellitic acid anhydride, trimellitic acid anhydride, and benzophenone tetracarboxylic acid; and a mixture thereof. Particularly, it is desirable to use polyhydric phenols such as phenol novolak in view of its low water absorption properties. It is also possible to use a so-called "amino triazine novolak resin (ATN)", which is obtained by adding a compound having a triazine structure such as melamine or benzoguanamine to the phenolic raw material. A cured resin of ATN is known to have a high flame retardancy and, thus, ATN is expected to produce the effect of imparting a flame retardancy to the resin composition.

The mixing ratio of the epoxy resin curing agent can be determined optionally in view of the combination with the epoxy resin used. In general, the mixing ratio of the epoxy resin curing agent is set at a high level in order to increase the glass transition temperature of the resin composition. For example, where phenol novolak is used as the epoxy resin curing agent, it is desirable to mix the epoxy resin curing agent in a manner to set up the ratio of the epoxy equivalent to the phenolic hydroxyl group equivalent at 1 : 1, though this ratio is not applicable to the case of using ATN as the curing agent because the adjustment is required depending on the ratio of the phenolic component to the amino triazine component.

It is possible to add a known curing catalyst to the insulating resin composition of the present invention in order to promote the curing reaction. For example, where an epoxy resin is used as the thermosetting resin, the curing agent used in the present invention includes, for example, organic phosphine compounds such as triphenyl phosphine, tri-4-methyl phenyl phosphine, tri-4-methoxy phenyl phosphine, tributyl phosphine, trioctyl phosphine, tri-2-cyano ethyl phosphine; tetraphenyl borates of these organic phosphine compounds; tertiary amines such as tributyl amine, triethyl amine, 1,8-diaza bicyclo (5,4,0) undecene-7-triamyl amine; quaternary ammonium salts such as chlorobenzyl trimethyl ammonium, hedroxybenzyl trimethyl ammonium, triethyl ammonium tetraphenyl borate; and imidazoles such as 2-ethyl imidazole, and 2-ethyl-4-methyl imidazole. Particularly, it is desirable to use organic phosphine compounds and the imidazoles as the curing catalyst. It is more desirable to use the phosphine compounds because it is possible to further improve the insulation reliability.

The mixing ratio of these curing catalyst can be determined optionally in a manner to obtain a desired gel time. In general, it is preferably to determine the mixing ratio such that the gel time falls within a range of between 1 minute and 15 minutes under a predetermined temperature falling within a range of between 80°C and 250°C.

The insulating resin composition of the present invention also comprises a filler as component (iii). It is possible to use known fillers as component (iii). For example, it is possible to use organic fillers such as an epoxy resin powder, a melamine resin powder, an urea resin powder, a guanamine resin powder and a polyester resin powder, and inorganic fillers such as silica, alumina, and titanium oxide.

It is desirable for the filler to have an average particle diameter falling within a range of between 0.1 µm and 3 µm. If the average particle diameter of the filler is smaller than 0.1 µm, the filler particles tend to be agglomerated. Also, the viscosity of the varnish is increased and, thus, it is difficult to handle the varnish, leading to a poor workability. Further, the contribution to the coarsening effect tends to be diminished in the surface coarsening step. On the other hand, if the average particle diameter of the filler exceeds 3 µm, the phase separation structure is rendered coarse, with the result that the surface is made excessively coarse in the surface coarsening step in the copper plating process. It follows that the surface is not adapted for formation of a fine wiring pattern.

In an insulating resin composition for a multi-layered printed circuit wiring board, it is possible to add an inorganic or organic filler in order to improve the bonding strength with an electroless plating layer formed in general on the insulating layer and in order to lower the thermal expansion coefficient. Particularly, it is desirable to use a silica filler because the silica filler has a low dielectric constant, is low in its linear expansion coefficient, and is liberated from the insulating resin by the surface coarsening treatment such as under an alkaline atmosphere or a treatment with an oxidizing agent so as to easily form an anchor.

In the present invention, it is possible to use various silica fillers including, for example, various synthetic silica synthesized by a wet process or a dry process, a pulverized silica prepared by pulverizing a silica stone, and a molten silica that was once melted. The silica filler that can be used in the present invention is required to be dispersed in the fine phase separation structure for making finer the surface shape after the chemical coarsening treatment. Therefore, it is desirable for the silica filler to have an average primary particle diameter falling within a range of between 0.1 µm and 3 µm.

Concerning the mixing ratio of the filler in the present invention, it is desirable for the filler content to fall within a range of between 5% by weight and 40% by weight based on the total solid components of the resins. If the mixing ratio of the filler is larger than 40% by weight, the insulating resin is rendered brittle, resulting in failure to impart a high toughness to the thermoplastic resin, particularly, polyether sulfone. On the other hand, if the mixing ratio of the filler is smaller than 5% by weight, it is difficult to obtain a chemical coarsening, resulting in failure to obtain a sufficiently high plating strength.

For preparing a coating solution of the insulating resin composition of the present invention, it is desirable to use a solvent that does not remain in the coated layer when the coated layer is dried and baked. It should also be noted that the polyether sulfone used in the present invention has a high molecular weight and, thus, tends to be gelled in the solvent. Under the circumstances, it is desirable to select a solvent compatible with the polyether sulfone. For example, the solvent used in the present invention is selected from the group consisting of acetone, methyl ethyl ketone (MEK), toluene, xylene, n-hexane, methanol, ethanol, methyl cellosolve, ethyl cellosolve, cyclohexanone, N,N-dimethyl acetamide, methyl isobutyl ketone (MIBK), 4-butylolactone, dimethyl formamide (DMF), n-methyl-2-pyrrolidone (NMP), and a mixture thereof.

Further, it is possible to add, as required, additives such as a thermal polymerization inhibitor, a plasticizer, a leveling agent, a defoaming agent, an ultraviolet light absorber, and a flame retardant and a pigment for coloring to the insulating resin composition of the present invention.

The fine phase separation structure defined in the present invention includes a sea-island structure, a connected-globule structure, a composite dispersion phase structure and a co-continuous phase structure which structures have, preferably, a pitch size of a periodic distance not larger than about 5 µm.

According to a preferred embodiment of the present invention, it is possible to set the pitch at a level not higher than about 3 µm by adding the second thermosetting resin.

Also, where the fine phase separation structure is any one of the sea-island structure, the connected-globule structure and the composite dispersion phase structure, it is desirable for the filler to be unevenly distributed within the spherical domain of the structure. It is also desirable for the average size of the spherical domain to fall within a range of between 0.1 µm and 5 µm, more preferably, between 0.1 µm and 3 µm. According to a preferred embodiment of the present invention, the addition of the second thermosetting resin tends to cause a pitch size such as an average size of the spherical domain tends to fall within a range of between 0.1 µm and 3 µm.

If the pitch size is smaller than 0.1 µm, it is impossible to obtain a sufficient bonding strength between the insulating resin and the copper layer in the electroless plating performed after the surface coarsening step, the effect of improving the toughness of the cured resin tends to be lowered. On the other hand, if the pitch size exceeds 5 µm, the surface is rendered excessively coarse in the surface coarsening step of the copper plating, which is disadvantageous for forming a fine wiring pattern.

Further, it is preferable for the fine phase separation structure to consist of the composite dispersion phase structure or the continuous spherical phase structure and for the filler to be presented in the thermosetting resin rich phase.

Incidentally, each of the sea-island structure, the composite dispersion phase structure and the co-continuous phase structure (or continuous phase structure) is described in detail in "Polymer Alloy, page 325, (1993), Tokyo Kagaku Dojin". On the other hand, the connected-globule structure is described in detail in "Keizo Yamanaka and Takashi Inoue, POLYMER, Vol. 30, pp. 662 (1989)".

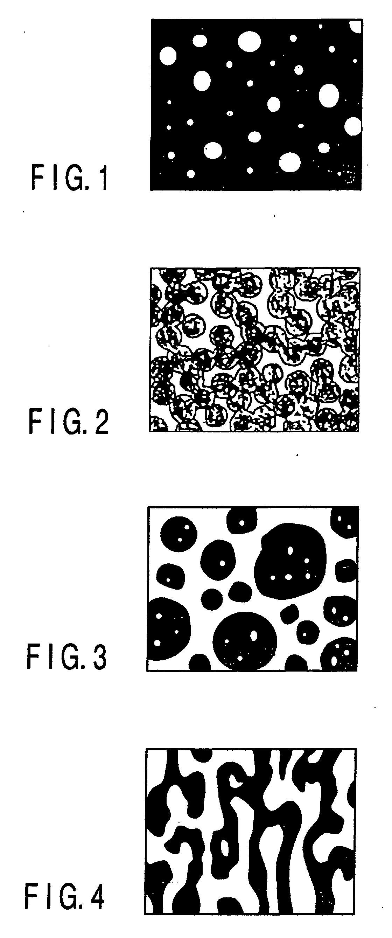

FIGS. 1 to 4 show as models the sea-island structure, the connected-globule structure, the composite dispersion phase structure and the co-continuous phase structure, respectively, described in the publications referred to above.

The particular fine phase separation structure can be obtained by controlling the curing conditions such as the catalyst species of the insulating resin composition and the reaction temperature, and by controlling the compatibility among the components of the insulating resin composition. It is possible to facilitate the generation of the phase separation by, for example, lowering the compatibility with PES by using an alkyl-substituted epoxy resin or, in the case of the same composition system, by increasing the curing temperature or by retarding the curing rate by selecting the suitable catalyst species.

For example, when it comes to an insulating resin composition containing as main components an epoxy resin, a polyether sulfone and silica, the polyether sulfone and the epoxy resin are mixed without adding the filler. Also, the material composition which permits forming a fine connected-globule structure, when cured, having a spherical domain not larger than about 3 to 5 µm is examined in advance. Then, a fine silica filler having an average particle diameter falling within a range of between 0.1 µm and 3 µm is added to the mixture of the polyether sulfone and the epoxy resin. In this case, it is possible to obtain a cured material having a fine phase separation structure, in which the filler is distributed in the epoxy resin rich phase, by optimizing the reaction temperature and the reaction rate. In other words, it is possible to permit the filler to be dispersed selectively in the epoxy resin rich phase alone.

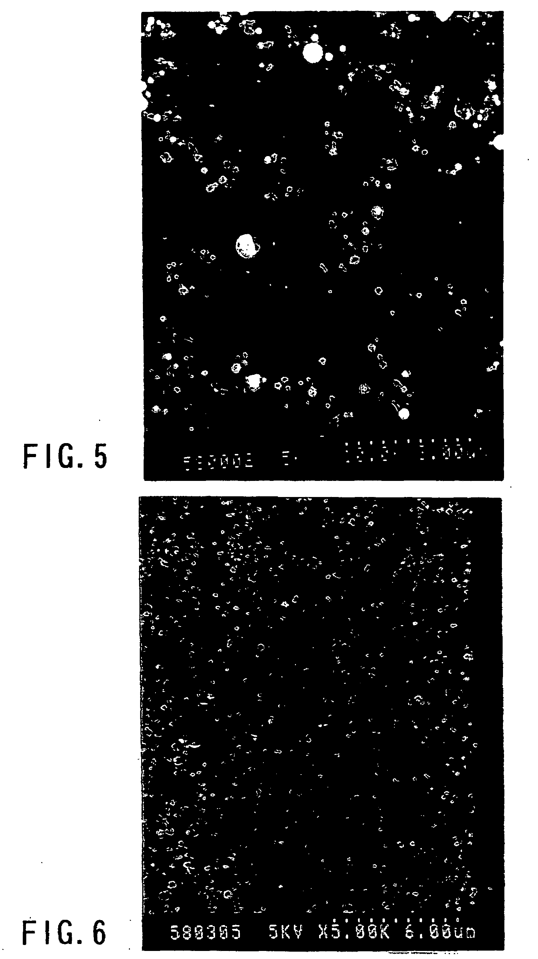

FIG. 5 is a scanning electron micrograph showing as an example the surface structure of the insulating resin film thus obtained. As shown in the scanning electron micrograph, the insulating resin film has a co-continuous phase structure consisting of the polyether sulfone rich phase and the epoxy resin rich phase, and silica is selectively dispersed in the epoxy resin rich phase alone. Also, the pitch was found to be about 3 µm.

Also, when it comes to the insulating resin composition containing as main components two different kinds of epoxy resins, a polyether sulfone and silica, an epoxy resin capable of forming a connected-globule structure when mixed with the polyether sulfone and cured is selected as the first epoxy resin. Further, examined in advance are the composition ratio of the first epoxy resin to the polyether sulfone and the curing conditions which permit forming a fine connected-globule structure having a spherical domain of about 3 to 5 µm when the mixture of the first epoxy resin and the polyether sulfone is cured without adding the filler. Similarly, an epoxy resin having a miscible structure when mixed with the polyether sulfone and cured is selected as a second epoxy resin. It is possible to obtain an insulating resin layer of a fine phase separation structure having a spherical domain falling within a range of between about 0.1 µm and about 3 µm by adding a suitable amount of the selected second epoxy resin to the mixture of the first epoxy resin and the polyether sulfone, the mixture having the composition ratio examined in advance, and by optimizing again the reaction temperature and the reaction rate.

In the case of the insulating resin composition described above, it is possible to obtain a cured material having a fine phase separation structure and having the filler selectively dispersed in the epoxy resin rich phase by adding a fine filler consisting of silica and having an average particle diameter of 0.1 to 3 µm and by optimizing again the reaction temperature and the reaction rate.

FIG. 6 is an scanning electron micrograph showing as an example the surface structure of the insulating resin film thus obtained.

As apparent from the scanning electron micrograph, the insulating resin film has a co-continuous phase separation structure consisting of the polyether sulfone rich phase and the epoxy resin rich phase, and silica is selectively dispersed in the epoxy resin rich phase alone. It is also seen that the pitch is very, i.e., about 1 µm to 2 µm. Since the surface has a phase separation structure of the small pitch, it is possible to form a fine wiring pattern. And also a bonding strength becomes higher.

As described above, the insulating resin composition of the present invention forms a sea-island structure or a connected-globule structure when a filler is not added to the composition and is capable of forming a resin insulating layer having a fine co-continuous phase structure or a composite dispersion phase structure when the filler is added to the composition.

A so-called "build-up" method will now be described in detail as a preferred example of the method of manufacturing a multi-layered printed circuit wiring board using the insulating material of the present invention.

In the first step, prepared is a base material having a first wiring pattern formed thereon. A substrate used as the base material includes, for example, a plastic substrate, a ceramic substrate, a metal substrate and a film substrate. To be more specific, it is possible to use as the base material a glass epoxy substrate, bismaleimide triazine substrate, an aramid fiber nonwoven fabric substrate, a liquid crystal polymer substrate, an aluminum substrate, an iron substrate and a polyimide substrate.

In the next step, the base material having the first wiring pattern is coated with the insulating material described above, followed by drying and curing the coated insulating material so as to form a resin insulating layer.

For forming the resin insulating layer on the base material having the first wiring pattern formed thereon, it is possible to employ the coating method by various means such as a roll coat method, a dip coat method, a spray coating method, a spinner coating method, a curtain coating method, a slot coating method and a screen printing method. It is also possible to employ the method of attaching a dry film, which is prepared by processing a mixed liquid containing the insulating resin composition of the present invention into a film, to the base material having the first wiring pattern formed thereon.

The dry film is used preferably because it is possible to carry out the manufacturing process of the printed circuit wiring board by the dry process.

The dry film can be formed on a sheet like supporting member. For example, it is possible to prepare an insulating resin transfer sheet for a multi-layered printed circuit wiring board by, for example, dissolving the resin composition of the present invention in a solvent, mechanically dispersing the filler of the present invention in the resin composition so as to obtain a varnish, coating a sheet-like supporting member such as a PET sheet with the varnish thus obtained, and finally removing the solvent by the drying.

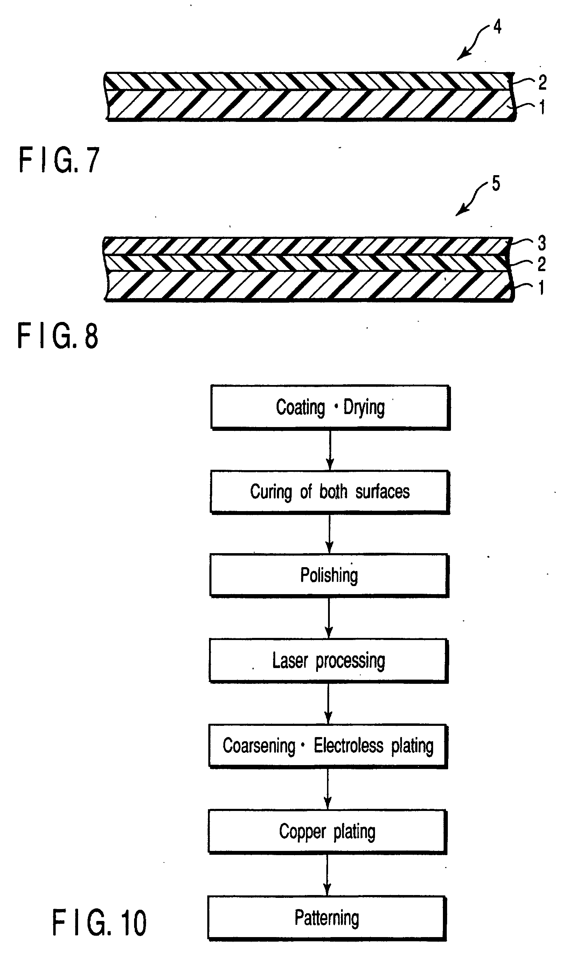

FIG. 7 schematically shows the construction of an insulating resin transfer sheet for a multi-layered printed circuit wiring board formed on the supporting body. A reference numeral 1 shown in FIG. 7 denotes a supporting film, a reference numeral 2 denotes a dry film formed by using the insulating resin composition of the present invention, and a reference numeral 4 denotes an insulating resin transfer sheet for a multi-layered printed circuit wiring board.

It is possible to obtain a film of a three-layer structure consisting of a supporting film, a dry film and a polyethylene film by forming the polyethylene film as a protective film on the surface of the dry film described above.

FIG. 8 schematically shows the construction of an insulating resin transfer sheet for a multi-layered printed circuit wiring board, which is of a three-layer structure including the dry film. A reference numeral 1 shown in FIG. 8 denotes a supporting film, a reference numeral 2 denotes a dry film formed by using the insulating resin composition of the present invention, a reference numeral 3 denotes a protective film, which can be peeled off, formed on the dry film 2, and a reference numeral 5 denotes a film laminated member.

When the insulating resin transfer sheet is used, the protective film is peeled off and the insulating resin transfer sheet is applied to the base material having a wiring pattern formed thereon.

It is possible to form a peeling layer, as required, in at least one of the positions between the supporting film 1 and the dry film 2 and between the dry film 2 and the protective film 3.

For preparing the varnish, it is desirable to select a solvent compatible with the polyether sulfone. For example, the solvent used in the present invention is selected from the group consisting of acetone, methyl ethyl ketone (MEK), toluene, xylene, n-hexane, methanol, ethanol, methyl cellosolve, ethyl cellosolve, cyclohexanone, N,N-dimethyl acetamide, methyl isobutyl ketone (MIBK), 4-butylolactone, dimethyl formamide (DMF), and n-methyl-2-pyrrolidone (NMP).

In order to impart flexibility to the dry film, it is possible to dry the coated varnish to an extent that 3% by weight to 25% by weight of the solvent remains in the film. The optimum remaining amount of the solvent in the dry film can be selected in various fashions depending on the contents of the flexible components in the resin such as the thermoplastic resin including the polyether sulfone and the liquid epoxy compound. If the remaining amount of the solvent in the dry film is smaller than 3% by weight, cracks tend to be generated so as to lower the bonding strength with the supporting film or with the polyethylene film. On the other hand, if the remaining amount of the solvent exceeds 25% by weight, tackiness are generated on the surface of the film, with the result that a prior adhesion is brought about in the laminating step. It follows that it is impossible to obtain a uniform surface of the dry film.

In general, the suitable thickness of the resin insulating layer falls within a range of between about 20 µm and about 100 µm. However, where particularly high insulating properties are required, it is possible to make the resin insulating layer thicker than the range noted above.

Preferably, the heating treatment includes a pre-curing step that is carried out at 60 to 120°C for 30 minutes to 2 hours and a curing step that is carried out at 150 to 220°C for 30 minutes to 4 hours. More preferably, the heating treatment includes a pre-curing step that is carried out at 80 to 100°C for 50 to 90 minutes and a curing step that is carried out at 180 to 190°C for 1 to 2 hours.

If the pre-curing step is carried out under temperatures lower than 60°C, the time for evaporating the solvent from the coated layer tends to become longer. If the temperature in the pre-curing step is higher than 120°C, however, a phase separation is brought about in the stage of the pre-curing step, with the result that the phase separation structure of the cured insulating layer tends to be coarse.

Also, if the pre-curing time is shorter than 30 minutes, the solvent tends to remain in the coated layer in an excessively large amount. On the other hand, if the pre-curing time exceeds 2 hours, the curing reaction of the epoxy resin slightly takes place, with the result that the heat resistance of the final cured material tends to be lowered.

Further, if the curing temperature is lower than 150°C, the glass transition point (Tg) of the insulating layer is lowered, which is not desirable in view of the heat resistance. If the curing temperature exceeds 220°C, however, the base material is deteriorated. In addition, the bonding strength of the wiring pattern tends to be lowered by the repeated curing in the build-up step.

Still further, if the curing time is shorter than 30 minutes, the insulating layer fails to be cured sufficiently, with the result that various properties tend to be lowered by the decrease of the glass transition point Tg and by the influence given by the remaining solvent. On the other hand, if the curing time exceeds 4 hours, the yield tends to be made poor.

After the curing treatment, it is possible to apply, as required, a polishing treatment to the surface of the resin insulating layer. It is also possible to apply, as required, a surface coarsening treatment to the surface of the resin insulating layer with an acid or an oxidizing agent.

In the next step, a metal layer for forming a wiring pattern is formed by applying an electroless plating or an electroplating to the resin insulating layer. The electroless plating method employed in the present invention includes, for example, an electroless copper plating, an electroless nickel plating, an electroless gold plating, an electroless silver plating, and an electroless tin plating. Incidentally, it is also possible to apply a different kind of the electroless plating or electroplating to the resin insulating layer to which an electroless plating was applied in advance. Alternatively, the plated resin insulating layer can be coated with a solder.

Also, it is possible to form, as required, a copper foil on the surface of the insulating material of the present invention under a semi-cured state so as to prepare a copper-clad laminate.

Incidentally, it is possible to form via holes by, for example, a laser treatment in the resin insulating layer after the curing for the electrical connection to each of the wiring patterns. The laser used for forming the via holes includes, for example, a CO2 gas laser, an UV/YAG laser, and an exicimer laser. A via hole sized smaller than the via hole formed by the so-called "photolithography" can be formed by using the laser. For example, the via hole formed by the photolithography has a diameter of about 80 µm. However, in the case of employing a UV/YAG laser, it is possible to form a via hole having a diameter of about 30 µm.

Preferably, the via hole is formed before an electroless plating layer is formed on the resin insulating layer. If the via hole is formed after formation of the electroless plating metal layer, an electroless metal layer is not formed within the via hole, resulting in failure to achieve an electrical connection through the via hole.

If an electroplating is performed by using the electroless plating metal layer formed previously as the electrode, it is possible to form an electroplating metal layer on the electroless plating metal layer.

A second wiring pattern can be formed by patterning the copper plating metal layer thus formed.

It is also possible to employ a so-called "semi-additive process", in which a copper electroplating is performed after the patterning of the electroless copper plating so as to obtain a wiring pattern.

It is possible to laminate wiring patterns by repeatedly applying the process described above to the second wiring pattern thus formed. A fine multi-layered wiring plate can be formed easily by employing the build-up method described above.

### EXAMPLES

The insulating resin composition and the multi-layered printed circuit wiring board of the present invention will now be described more in detail with references to the Examples of the present invention which follow.

It should be noted that the cross sectional structure of each insulating resin was observed with an SEM. Also, the composition of each phase was identified by EPMA.

### Example 1:

In the first step, prepared was a solution by dissolving 100.0 parts by weight of heat resistant epoxy resin (trade name TMH574 manufactured by Sumitomo Chemical Co., Ltd.) as a first thermosetting resin, 46.5 parts by weight of flame retardant epoxy resin (trade name E5050 manufactured by Yuka Shell Epoxy K.K.), 61.6 parts by weight of a phenolic resin manufactured by Nippon Kayaku Co., Ltd., and 89.2 parts by weight of terminal phenol modified polyether sulfone as a thermoplastic resin (trade name Sumika Excel 5003P manufactured by Sumitomo Chemical Co., Ltd.) in a mixed solvents consisting of 4-butylolactone and n-methyl-2-pyrollidone.

Dispersed in the resultant solution by a kneading roll were 127.4 parts by weight of silica filler (trade name 1-FX manufactured by TATSUMORI LTD. average diameter 0.3 µm) and 0.3 parts by weight of curing catalyst (reagent name 2E4MZ manufactured by Tokyo Kasei Kogyo Co., Ltd.), followed by stirring and defoaming the dispersion so as to obtain an insulating resin composition for a multi-layered printed circuit wiring board.

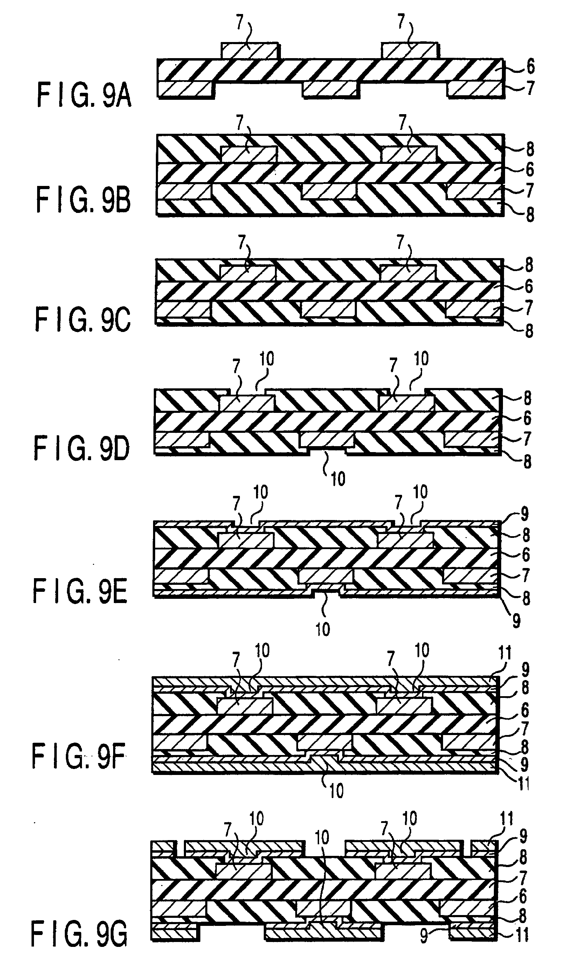

FIGS. 9A to 9G are cross sectional views collectively exemplifying the method of the present invention for manufacturing a multi-layered wiring board. On the other hand, FIG. 10 is a block diagram for explaining the process of the present invention for manufacturing a multi-layered wiring board.

As shown in FIG. 9A, prepared first was a glass epoxy substrate 6 having copper wiring patterns 7, to which a blackening treatment was applied previously, formed on the both surfaces. Then, as shown in FIG. 9B, the both surfaces of the substrate 6 were coated with an insulating resin composition for a multi-layered printed circuit wiring board in a thickness of about 40 µm (thickness of one resin composition layer) by using a spin coater, followed by applying a thermal curing treatment by using a drying oven at 80°C for 1 hour and, then, at 180°C for 2 hours so as to form a resin insulating layer 8. After formation of the resin insulating layer 8, the surface of the resin insulating layer 8 was polished, as shown in FIG. 9C.

After the polishing step, via holes 10 were formed by applying a UV/YAG laser processing to the surface of the resin insulating layer 8 such that the via holes 10 reached the copper wiring pattern 7, as shown in FIG. 9D, followed by removing the undesired burrs and the like by a smear removing treatment by a chemical coarsening using a chemical solution and subsequently applying an electroless plating so as to form an electroless plating layer 9, as shown in FIG. 9E.

In the next step, an electroplating was applied by using the electroless plating layer 9 as an electrode so as to form a copper plating layer 11 having a thickness of about 18 µm on the electroless plating layer 9, as shown in FIG. 9F, thereby obtaining a test sample. Incidentally, a multi-layered printed circuit wiring board was obtained by selectively etching the copper plating layer 11 with an etchant, as shown in FIG. 9G.

The sample thus obtained was tested and evaluated as follows. Table 1 shows the results. Table 1 also shows the experimental data covering the phase separation structure of the resin insulating layer cured by using a composition similar to the insulating resin composition described above, except that the filler was not added to the composition.

### Bonding Strength Test

The bonding strength was examined by a 90° peeling test of a pattern having a width of 1 cm in accordance with JIS (Japanese Industrial Standards)-C6481.

### Fine Conductive Layer Formability Test

In order to examine the capability of forming a fine conductive layer, formed on the resin insulating layer was a fine pattern (line/space = 20 µm/20 µm) by a semi-additive method, followed by observing the pattern shape with an optical microscope. The wiring pattern free from a defect from the top to the bottom of the pattern was evaluated as "good". The wiring pattern having the bottom edge portion partly removed was evaluated as "breakage of edge portion". Further, the wiring pattern that was seriously damaged was evaluated as "poor".

It has been confirmed that the resin insulating layer is subjected to a spenodal decomposition in the curing step, that a polyfunctional epoxy resin and the polyether sulfone collectively form a fine phase separation structure, and that the filler is selectively present substantially in the polyfunctional epoxy resin phase region.

### Thermal shock test

In order to examine the toughness of the insulating resin layer, a Thermal shock test was conducted by applying to the substrate 1000 cycles of cooling and heating between -65°C and 150°C so as to observe the crack occurrence on the insulating resin layer.

### Insulation Reliability Test

In order to examine the insulation reliability of the resin insulating layer, the insulation resistance value was measured for 100 hours under the conditions of 121°C, 85% and 20V by using a counter electrode pattern having a diameter of 1 cm. The resistance value not lower than 10⁶Ω was evaluated as "good".

### Reflow Reliability Test

In order to examine the reflow reliability of the plated pattern, the substrates having various conductor patterns formed thereon were subjected to a pretreatment for the hygroscopic preservation under the conditions of JEDEC LEVEL 1, followed by performing a solder reflow test 5 times under the temperature of 240°C so as to observe the inconveniences such as the pattern peeling. The sample in which the peeling did not take place in any of all the tests was evaluated as "OK", the sample in which the peeling took place in the fourth or fifth test was evaluated as "low pattern peeling", and the sample in which the peeling took place in the first to third test was evaluated as "high pattern peeling".

In Example 1, the wiring pattern was formed on only one surface of the substrate. However, it is possible to form the wiring patterns on the both surfaces of the substrate.

### Example 2:

In the first step, prepared was a solution by dissolving 100.0 parts by weight of heat resistant epoxy resin (trade name TMH574 manufactured by Sumitomo Chemical Co., Ltd.) as a first thermosetting resin, 46.5 parts by weight of flame retardant epoxy resin (trade name E5050 manufactured by Yuka Shell Epoxy K.K.), 61.6 parts by weight of a phenolic resin manufactured by Nippon Kayaku Co., Ltd., and 89.2 parts by weight of terminal phenol modified polyether sulfone as a thermoplastic resin (trade name Sumika Excel 5003P manufactured by Sumitomo Chemical Co., Ltd.) in a mixed solvents consisting of 4-butylolactone and n-methyl-2-pyrollidone.

Dispersed in the resultant solution by a kneading roll were 127.4 parts by weight of silica filler (trade name NIPGEL CX-200 manufactured by NIPPON SILICA INDUSTRIAL CO., LTD average diameter 1.7 µm) and 0.3 parts by weight of curing catalyst (reagent name 2E4MZ manufactured by Tokyo Kasei Kogyo Co., Ltd.), followed by stirring and defoaming the dispersion so as to obtain an insulating resin composition for a multi-layered printed circuit wiring board.

Then, a printed circuit wiring board was manufactured by using the insulating resin composition described above and evaluated by the methods similar to those employed in Example 1. Table 1 shows the results.

### Example 3:

In the first step, prepared was a solution by dissolving 100.0 parts by weight of heat resistant epoxy resin as a first thermosetting resin (trade name EOCN103S manufactured by Nippon Kayaku Co., Ltd.), 46.5 parts by weight of flame retardant epoxy resin (trade name E5050 manufactured by Yuka Shell Epoxy K.K.), 61.6 parts by weight of a phenolic resin manufactured by Nippon Kayaku Co., Ltd., and 89.2 parts by weight of terminal phenol modified polyether sulfone as a thermoplastic resin (trade name Sumika Excel 5003P manufactured by Sumitomo Chemical Co., Ltd.) in a mixed solvents consisting of 4-butylolactone and n-methyl-2-pyrollidone.

Dispersed in the resultant solution by a kneading roll were 127.4 parts by weight of silica filler (trade name Adma fine SO-C2 manufactured by ADMATECHS Co., Ltd. average diameter 0.5 µm) and 0.3 parts by weight of curing catalyst (reagent name 2E4MZ manufactured by Tokyo Kasei Kogyo Co., Ltd.), followed by stirring and defoaming the dispersion so as to obtain an insulating resin composition for a multi-layered printed circuit wiring board.

Then, a printed circuit wiring board was manufactured by using the insulating resin composition described above and evaluated by the methods similar to those employed in Example 1. Table 1 shows the results.

### Example 4:

In the first step, prepared was a solution by dissolving 100.0 parts by weight of heat resistant epoxy resin as a first thermosetting resin (trade name EPPN502H manufactured by Nippon Kayaku Co., Ltd.), 46.5 parts by weight of flame retardant epoxy resin (trade name E5050 manufactured by Yuka Shell Epoxy K.K.), 61.6 parts by weight of a phenolic resin manufactured by Nippon Kayaku Co., Ltd., and 89.2 parts by weight of terminal phenol modified polyether sulfone as a thermoplastic resin (trade name Sumika Excel 5003P manufactured by Sumitomo Chemical Co., Ltd.) in a mixed solvents consisting of 4-butylolactone and n-methyl-2-pyrollidone.

Dispersed in the resultant solution by a kneading roll were 127.4 parts by weight of silica filler (trade name Adma fine SO-C2 manufactured by ADMATECHS CO., LTD. average diameter 0.5 µm) and 0.3 parts by weight of curing catalyst (reagent name 2E4MZ manufactured by Tokyo Kasei Kogyo Co., Ltd.), followed by stirring and defoaming the dispersion so as to obtain an insulating resin composition for a multi-layered printed circuit wiring board.

Then, the insulating resin composition described above was subjected to a thermal curing treatment under 180°C for 2 hours by using a drying oven. Further, a printed circuit wiring board was manufactured and evaluated by the methods similar to those employed in Example 1. Table 1 shows the results.

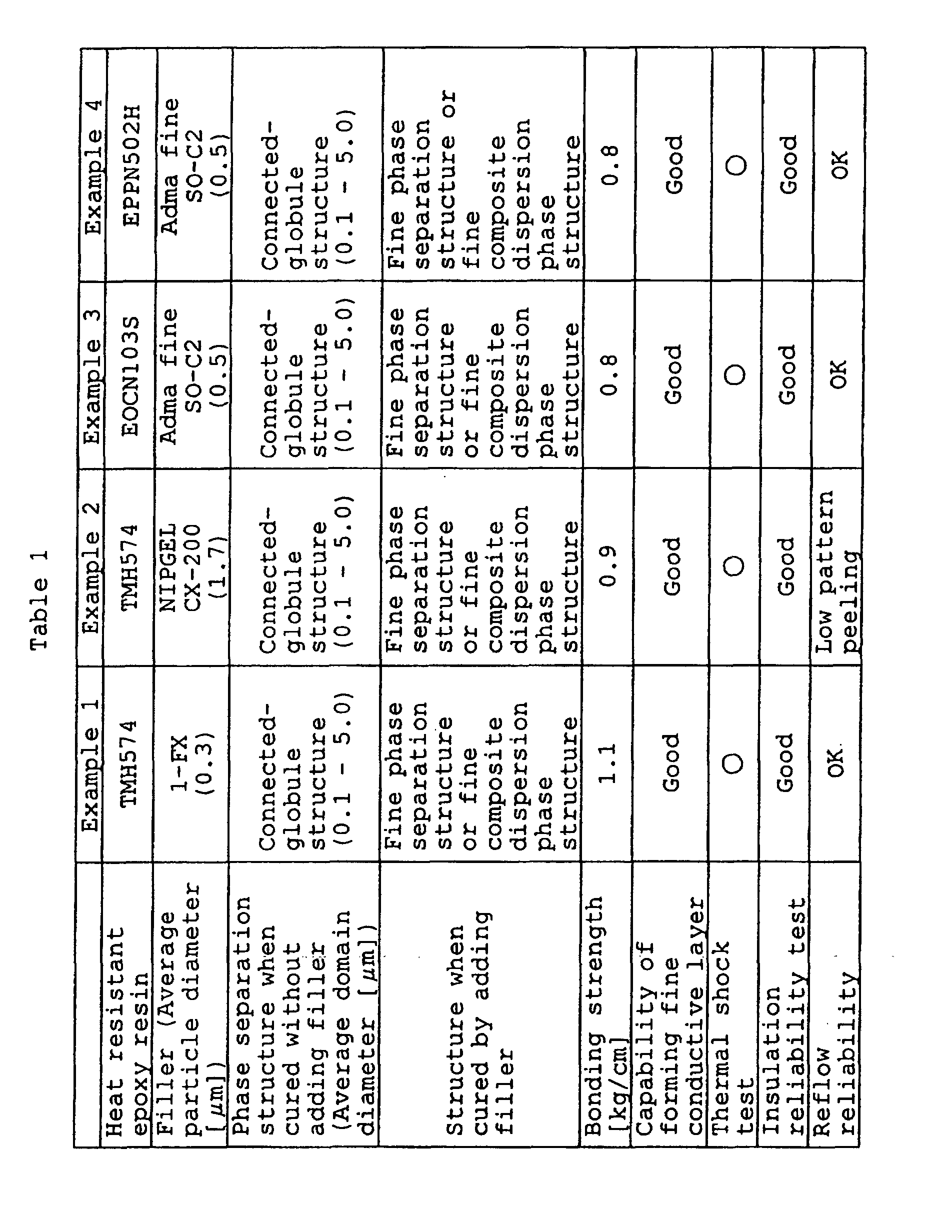

### Comparative Example 1:

In the first step, prepared was a solution by dissolving 100.0 parts by weight of heat resistant epoxy resin instead of a first thermosetting resin (trade name MY721 manufactured by Ciba-Geygy Ltd.), 46.5 parts by weight of flame retardant epoxy resin (trade name E5050 manufactured by Yuka Shell Epoxy K.K.), 61.6 parts by weight of a phenolic resin manufactured by Nippon Kayaku Co., Ltd., and 89.2 parts by weight of terminal phenol modified polyether sulfone as a termoplastic resin (trade name Sumika Excel 5003P manufactured by Sumitomo Chemical Co., Ltd.) in a mixed solvents consisting of 4-butylolactone and n-methyl-2-pyrollidone.

Dispersed in the resultant solution by a kneading roll were 127.4 parts by weight of silica filler (trade name Adma fine SO-C2 manufactured by ADMATECHS CO., LTD. average diameter 0.5 µm) and 0.3 parts by weight of curing catalyst (reagent name 2E4MZ manufactured by Tokyo Kasei Kogyo Co., Ltd.), followed by stirring and defoaming the dispersion so as to obtain an insulating resin composition for a multi-layered printed circuit wiring board.

Then, a resin layer was formed by using the insulating resin composition described above under the conditions of 180°C and 2 hours. Further, a printed circuit wiring board was manufactured and evaluated by the methods similar to those employed in Example 1. Table 2 shows the results.

### Comparative Example 2:

In the first step, prepared was a solution by dissolving 100.0 parts by weight of heat resistant epoxy resin instead of a first thermosetting resin (trade name 157S70 manufactured by Nippon Kayaku Co., Ltd.), 46.5 parts by weight of flame retardant epoxy resin (trade name E5050 manufactured by Yuka Shell Epoxy K.K.), 61.6 parts by weight of a phenolic resin manufactured by Nippon Kayaku Co., Ltd., and 89.2 parts by weight of terminal phenol modified polyether sulfone (trade name Sumika Excel 5003P manufactured by Sumitomo Chemical Co., Ltd.) in a mixed solvents consisting of 4-butylolactone and n-methyl-2-pyrollidone.

Dispersed in the resultant solution by a kneading roll were 127.4 parts by weight of silica filler (trade name 1-FX manufactured by TATSUMORI LTD.) and 0.3 parts by weight of curing catalyst (reagent name 2E4MZ manufactured by Tokyo Kasei Kogyo Co., Ltd.), followed by stirring and defoaming the dispersion so as to obtain an insulating resin composition for a multi-layered printed circuit wiring board.

Then, a printed circuit wiring board was manufactured by using the insulating resin composition described above and evaluated by the methods similar to those employed in Example 1. Table 2 shows the results.

### Example 5:

In the first step, prepared was a solution by dissolving 100.0 parts by weight of heat resistant epoxy resin as a first thermosetting resin (trade name TMH574 manufactured by Sumitomo Chemical Co., Ltd.), 25.1 parts by weight of flame retardant epoxy resin (trade name E5050 manufactured by Yuka Shell Inc.), 56.0 parts by weight of a phenolic resin manufactured by Nippon Kayaku Co., Ltd., and 60.4 parts by weight of a terminal phenol modified polyether sulfone (Sumika Excel 5003P manufactured by Sumitomo Chemical Co., Ltd.) in a mixed solvents consisting of 4-butylolactone and n-methyl-2-pyrollidone.

Dispersed in the resultant solution by a kneading roll were 103.5 parts by weight of silica filler (trade name NIPGEL AY-460 manufactured by NIPPON SILICA INDUSTRIAL CO., LTD average diameter 3.0 µm) and 0.2 parts by weight of curing catalyst (reagent name 2E4MZ manufactured by Tokyo Kasei Kogyo Co., Ltd.), followed by stirring and defoaming the dispersion so as to obtain an insulating resin composition for a multi-layered printed circuit wiring board.

Then, a printed circuit wiring board was manufactured by using the insulating resin composition described above and evaluated by the methods similar to those employed in Example 1. Table 2 shows the results.

### Example 6:

In the first step, prepared was a solution by dissolving 100.0 parts by weight of heat resistant epoxy resin as a first thermosetting resin (trade name TMH574 manufactured by Sumitomo Chemical Co., Ltd.), 46.5 parts by weight of flame retardant epoxy resin (trade name E5050 manufactured by Yuka Shell Epoxy K.K.), 61.6 parts by weight of a phenolic resin manufactured by Nippon Kayaku Co., Ltd., and 89.2 parts by weight of terminal phenol modified polyether sulfone as a thermoplastic resin (trade name Sumika Excel 5003P manufactured by Sumitomo Chemical Co., Ltd.) in a mixed solvents consisting of 4-butylolactone and n-methyl-2-pyrollidone.

Dispersed in the resultant solution by a kneading roll were 127.4 parts by weight of resin filler (trade name SBX-6 manufactured by SEKISUI PLASTICS Co., Ltd. average diameter 6.0 µm) and 0.3 parts by weight of curing catalyst (reagent name 2E4MZ manufactured by Tokyo Kasei Kogyo Co., Ltd.), followed by stirring and defoaming the dispersion so as to obtain an insulating resin composition for a multi-layered printed circuit wiring board.

Then, a printed circuit wiring board was manufactured by using the insulating resin composition described above and evaluated by the methods similar to those employed in Example 1. Table 2 shows the results.

### Comparative Example 3:

In the first step, prepared was a solution by dissolving 100.0 parts by weight of heat resistant epoxy resin as a first thermosetting resin (trade name TMH574 manufactured by Sumitomo Chemical Co., Ltd.), 46.5 parts by weight of flame retardant (trade name E5050 epoxy resin manufactured by Yuka Shell Epoxy K.K.), 61.6 parts by weight of a phenolic resin manufactured by Nippon Kayaku Co., Ltd., and 89.2 parts by weight of terminal phenol modified polyether sulfone as a thermoplastic resin (trade name Sumika Excel 5003P manufactured by Sumitomo Chemical Co., Ltd.) in a mixed solvents consisting of 4-butylolactone and n-methyl-2-pyrollidone.

Then, a printed circuit wiring board was manufactured by using the insulating resin composition described above and evaluated by the methods similar to those employed in Example 1. Table 2 shows the results.

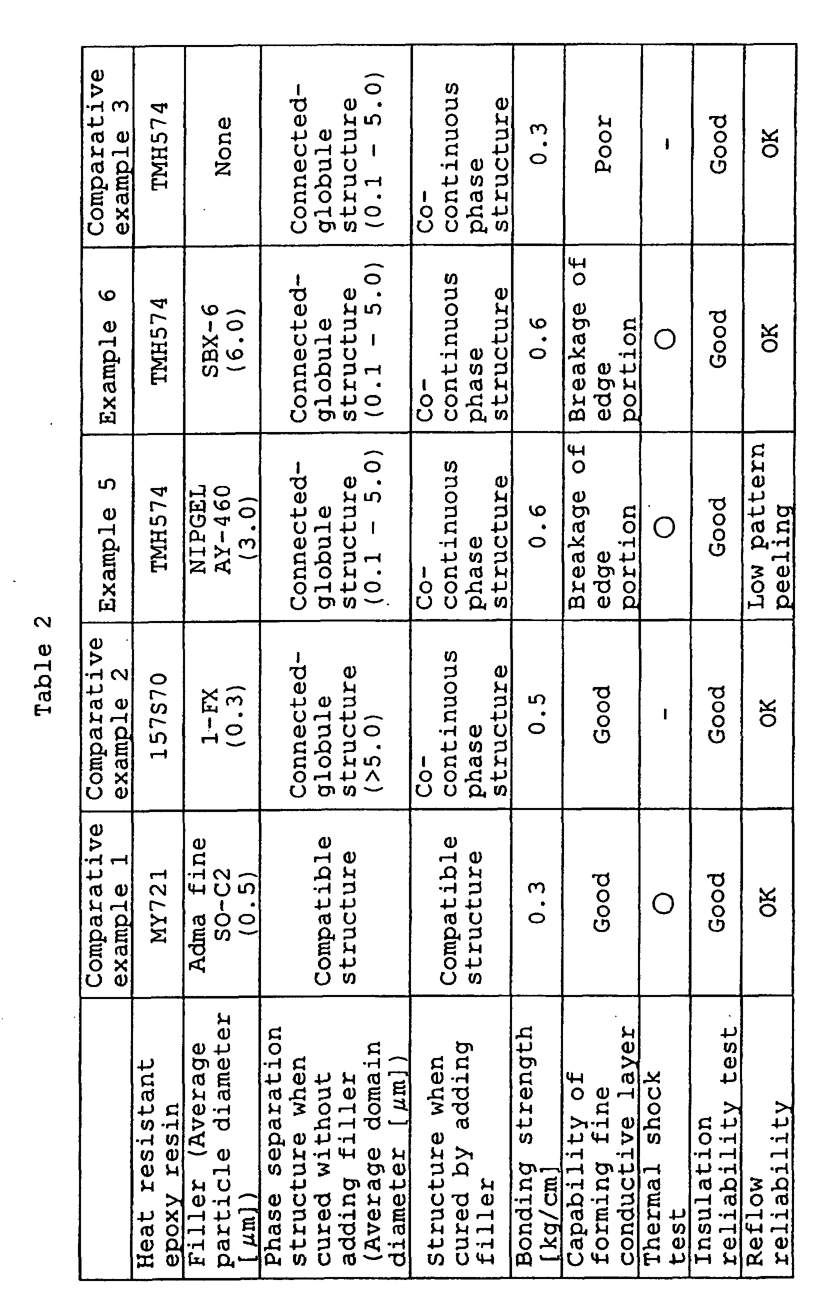

As apparent from Tables 1 and 2, it has been confirmed that each of the heat resistant epoxy resins TMH574, EOCM103S and EPPN502H forms a fine connected-globule structure sized at 0.1 µm to 5 µm, if cured without adding a filler. On the other hand, the heat resistant epoxy resin MY721 forms a miscible structure in which a clear phase separation structure cannot be recognized when observed with an SEM, if the epoxy resin is cured without adding a filler. Further, it has been confirmed that the heat resistant epoxy resin 157S70 forms a domain of a connected-globule structure sized not smaller than 5 µm.

It has also been confirmed by the Examples and the Comparative Examples reported above that the bonding strength can be increased by dispersing the silica filler in the insulating resin of the present invention. On the other hand, it has been confirmed that the heat resistant epoxy resin MY721 used in Comparative Example 1 is low in its bonding strength. It is considered reasonable to understand that, since the insulating resin specified in the present invention does not assume a fine phase separation structure, a high toughness is not sufficiently imparted to the polyether sulfone.

It has also been found that, in the case of using a polyfunctional epoxy resin forming a domain not larger than 5 µm when cured without adding a filler and of using a silica filler having a particle diameter falling within a range of between 0.1 µm and 3 µm, it is possible to form a fine wiring pattern (line/space = 20 µm/20 µm). Further, it has been found that all the insulating resin compositions used for forming a fine wiring pattern exhibit a high resistance to the Thermal shock test.

It has been confirmed the Examples 5 and 6 reported above that the capability of forming fine conductive layer and the reflow reliability tends to be slightly deteriorated but it can be practical when the size of filler is not less than 3.0 µm.

Still further, it has been found that, in the case of using the silica filler prepared by the dry method and the resin filler, the resultant resin composition is capable of maintaining high insulating properties and a high resistance to heat.

Examples according to a preferred embodiment of the present invention will now be described.

### Example 7:

In the first step, prepared was a solution by dissolving 100.0 parts by weight of polyether sulfone as a thermoplastic resin (trade name Sumika Excel 5003P manufactured by Sumitomo Chemical Co., Ltd.), 166.8 parts by weight of polyfunctional epoxy resin as a first thermosetting resin (trade name TMH574 manufactured by Sumitomo Chemical Co., Ltd.), 96.2 parts by weight of bisphenol A type epoxy resin as a second thermosetting resin (trade name Epikote 828EL manufactured by Yuka Shell Epoxy K.K.), and 137.1 parts by weight of a phenolic resin manufactured by Nippon Kayaku Co., Ltd. in a mixed solvents consisting of 4-butylolactone and n-methyl-2-pyrollidone.

Dispersed in the resultant solution by a kneading roll were 125.0 parts by weight of silica filler (trade name 1-FX manufactured by TATSUMORI LTD.), 0.5 parts by weight of curing catalyst 2-ethyl-4-methyl imidazole (reagent name 2E4MZ manufactured by Tokyo Kasei Kogyo Co., Ltd.), and 3.8 parts by weight of a silane coupling agent manufactured by Shin-Etsu Chemical Co., Ltd., followed by stirring and defoaming the dispersion so as to obtain an insulating resin composition for a multi-layered printed circuit wiring board.

Then, a printed circuit wiring board was manufactured as in Example 1 by using the insulating resin composition described above.

The sample thus prepared was tested and evaluated as follows. Table 3 shows the results. Table 3 also shows the experimental data relating to the phase separation structure of the resin insulating layer prepared by curing a resin composition equal to the insulating resin composition described above, except that a filler was not added to the resin composition.

### Bonding Strength Test

The bonding strength test was conducted as in Example 1.

### Glass Transition Point Measuring Test

A dynamic viscoelasticity was measured by using DMS6100 manufactured by Seiko Denshi Kogyo K.K. and the glass transition point was obtained by a dissipation factor at 10 Hz.

### Phase Structure Observation Test

A cross section of the resin insulating layer was smoothed by a microtome, followed by a light etching with an alkali/permanganate solution and observation with an SEM so as to measure the pitch size of the fine phase separation structure.

### Fine Conductive Layer Formability Test

In order to examine the capability of forming a fine conductive layer, formed on the resin insulating layer was a fine pattern (line/space = 20 µm/20 µm) by a semi-additive method, followed by observing the pattern shape with an optical microscope. The wiring pattern free from a defect from the top to the bottom of the pattern was evaluated as "good". The wiring pattern having the bottom edge portion partly removed was evaluated as "breakage of edge portion". Further, the wiring pattern that was seriously damaged was evaluated as "poor".

### Example 8:

In the first step, prepared was a solution by dissolving 100.0 parts by weight of terminal phenol group modified polyether sulfone as a thermoplastic resin (trade name Sumika Excel 5003P manufactured by Sumitomo Chemical Co., Ltd.), 183.8 parts by weight of polyfunctional epoxy resin as a first thermosetting resin (trade name TMH574 manufactured by Sumitomo Chemical Co., Ltd.), 65.5 parts by weight of a glycidyl amine type epoxy resin as a second thermosetting resin (trade name Araldite MY721 manufactured by Ciba Geigey Inc.), and 160.0 parts by weight of a phenolic resin manufactured by Nippon Kayaku Co., Ltd. in a mixed solvents consisting of 4-butylolactone and n-methyl-2-pyrollidone.

Dispersed in the resultant solution by a kneading roll were 125.1 parts by weight of silica filler (trade name 1-FX manufactured by TATSUMORI LTD. average diameter 0.3 µm), 0.5 parts by weight of 2-ethyl-4-methyl imidazole, which is a curing catalyst manufactured by Tokyo Kasei Kogyoco., Ltd., and 3.8 parts by weight of a silane coupling agent manufactured by Shin-Etsu Chemical Co., Ltd., followed by stirring and defoaming the dispersion so as to obtain an insulating resin composition for a multi-layered printed circuit wiring board.

Then, a printed circuit wiring board was manufactured as in Example 1 by using the insulating resin composition described above.

The sample thus prepared was tested and evaluated as in Example 7. Table 3 shows the results.

### Example 9:

In the first step, prepared was a solution by dissolving 100.0 parts by weight of terminal phenol group modified polyether sulfone as a thermoplastic resin (trade name Sumika Excel 5003P manufactured by Sumitomo Chemical Co., Ltd.), 84.0 parts by weight of polyfunctional epoxy resin as a first thermosetting resin (trade name EPPN-502H manufactured by Nippon Kayaku Co., Ltd.), 61.6 parts by weight of bisphenol A type epoxy resin as a second thermosetting resin (trade name Epikote 828EL manufactured by Yuka Shell Epoxy K.K.), and 87.8 parts by weight of a phenolic resin manufactured by Nippon Kayaku Co., Ltd. in a mixed solvents consisting of 4-butylolactone and n-methyl-2-pyrollidone.

Dispersed in the resultant solution by a kneading roll were 83.3 parts by weight of silica filler (trade name 1-FX manufactured by TATSUMORI LTD. average diameter 0.3 µm), 0.3 parts by weight of 2-ethyl-4-methyl imidazole, which is a curing catalyst manufactured by Tokyo Kasei Kogyo Co., Ltd., and 2.5 parts by weight of a silane coupling agent manufactured by Shin-Etsu Chemical Co., Ltd., followed by stirring and defoaming the dispersion so as to obtain an insulating resin composition for a multi-layered printed circuit wiring board.

Then, a printed circuit wiring board was manufactured as in Example 1 by using the insulating resin composition described above.

The sample thus prepared was tested and evaluated as in Example 7. Table 3 shows the results.

### Example 10:

In the first step, prepared was a solution by dissolving 100.0 parts by weight of terminal phenol group modified polyether sulfone as a thermoplastic resin (trade name Sumika Excel 5003P manufactured by Sumitomo Chemical Co., Ltd.), 79.5 parts by weight of polyfunctional epoxy resin as a first thermosetting resin (trade name EPPN-502H manufactured by Nippon Kayaku Co., Ltd.), 54.1 parts by weight of glycidyl amine type epoxy resin as a second thermosetting resin (trade name Araldite MY721 manufactured by Ciba-Geygy Ltd.), and 99.7 parts by weight of a phenolic resin manufactured by Nippon Kayaku Co., Ltd. in a mixed solvents consisting of 4-butylolactone and n-methyl-2-pyrollidone.

Dispersed in the resultant solution by a kneading roll were 83.4 parts by weight of silica filler (trade name 1-FX manufactured by TATSUMORI LTD. average diameter 0.3 µm), 0.3 parts by weight of 2-ethyl-4-methyl imidazole, which is a curing catalyst manufactured by Tokyo Kasei Kogyo Co., Ltd., and 2.5 parts by weight of a silane coupling agent manufactured by Shin-Etsu Chemical Co., Ltd., followed by stirring and defoaming the dispersion so as to obtain an insulating resin composition for a multi-layered printed circuit wiring board.

Then, a printed circuit wiring board was manufactured as in Example 1 by using the insulating resin composition described above.

The printed circuit wiring board thus prepared was tested and evaluated as in Example 7. Table 3 shows the results.

### Example 11:

In the first step, prepared was a solution by dissolving 100.0 parts by weight of terminal phenol group modified polyether sulfone as a thermoplastic resin (trade name Sumika Excel 5003P manufactured by Sumitomo Chemical Co., Ltd.), 81.6 parts by weight of cresol novolak type epoxy resin as a first thermosetting resin (trade name EOCN-103S manufactured by Nippon Kayaku Co., Ltd.), 79.9 parts by weight of bisphenol A type epoxy resin as a second thermosetting resin (trade name Epikote 828EL manufactured by Yuka Shell Epoxy K.K.), and 80.8 parts by weight of a phenolic resin manufactured by Nippon Kayaku Co., Ltd. in a mixed solvents consisting of 4-butylolactone and n-methyl-2-pyrollidone.

Dispersed in the resultant solution by a kneading roll were 83.3 parts by weight of silica filler (trade name Adma fine SO-C2 manufactured by TATSUMORI LTD. average diameter 0.5 µm), 0.3 parts by weight of 2-ethyl-4-methyl imidazole, which is a curing catalyst manufactured by Tokyo Kasei Kogyo Co., Ltd., and 2.5 parts by weight of a silane coupling agent manufactured by Shin-Etsu Chemical Co., Ltd., followed by stirring and defoaming the dispersion so as to obtain an insulating resin composition for a multi-layered printed circuit wiring board.

Then, a printed circuit wiring board was manufactured as in Example 1 by using the insulating resin composition described above.

The sample thus prepared was tested and evaluated as in Example 7. Table 3 shows the results.

### Example 12:

In the first step, prepared was a solution by dissolving 100.0 parts by weight of terminal phenol group modified polyether sulfone as a thermoplastic resin (trade name Sumika Excel 5003P manufactured by Sumitomo Chemical Co., Ltd.), 59.4 parts by weight of cresol novolak type epoxy resin as a first thermosetting resin (trade name EOCN-103S manufactured by Nippon Kayaku Co., Ltd.), 31.9 parts by weight of glycidyl amine type epoxy resin as a second thermosetting resin (trade name Araldite MY721 manufactured by Ciba-Geygy Ltd.), and 58.8 parts by weight of a phenolic resin manufactured by Nippon Kayaku Co., Ltd. in a mixed solvents consisting of 4-butylolactone and n-methyl-2-pyrollidone.

Dispersed in the resultant solution by a kneading roll were 62.5 parts by weight of silica filler (trade name Adma fine SO-C2 manufactured by TATSUMORI LTD. average diameter 0.5 µm), 0.3 parts by weight of 2-ethyl-4-methyl imidazole, which is a curing catalyst manufactured by Tokyo Kasei Kogyo Co., Ltd., and 1.9 parts by weight of a silane coupling agent manufactured by Shin-Etsu Chemical Co., Ltd., followed by stirring and defoaming the dispersion so as to obtain an insulating resin composition for a multi-layered printed circuit wiring board.

Then, a printed circuit wiring board was manufactured as in Example 1 by using the insulating resin composition described above.

The sample thus prepared was tested and evaluated as in Example 7. Table 4 shows the results.

### Example 13:

In the first step, prepared was a solution by dissolving 100.0 parts by weight of terminal phenol group modified polyether sulfone as thermoplastic resin (trade name Sumika Excel 5003P manufactured by Sumitomo Chemical Co., Ltd.), 152.9 parts by weight of polyfunctional epoxy resin as a first thermosetting resin (trade name TMH574 manufactured by Sumitomo Chemical Co., Ltd.), 3.2 parts by weight of bisphenol A type epoxy resin (trade name Epikote 828EL manufactured by Yuka Shell Epoxy K.K.), and 77.2 parts by weight of a phenolic resin manufactured by Nippon Kayaku Co., Ltd. in a mixed solvents consisting of 4-butylolactone and n-methyl-2-pyrollidone.

Dispersed in the resultant solution by a kneading roll were 83.3 parts by weight of silica filler (trade name 1-FX manufactured by TATSUMORI LTD. average diameter 0.3 µm), 0.3 parts by weight of 2-ethyl-4-methyl imidazole, which is a curing catalyst manufactured by Tokyo Kasei Kogyo Co., Ltd., and 2.5 parts by weight of a silane coupling agent manufactured by Shin-Etsu Chemical Co., Ltd., followed by stirring and defoaming the dispersion so as to obtain an insulating resin composition for a multi-layered printed circuit wiring board.

Then, a printed circuit wiring board was manufactured as in Example 1 by using the insulating resin composition described above.

The sample thus prepared was tested and evaluated as in Example 7. Table 4 shows the results.

### Example 14:

In the first step, prepared was a solution by dissolving 100.0 parts by weight of terminal phenol group modified polyether sulfone as a thermoplastic resin (trade name Sumika Excel 5003P manufactured by Sumitomo Chemical Co., Ltd.), 78.8 parts by weight of polyfunctional epoxy resin as a first thermosetting resin (trade name TMH574 manufactured by Sumitomo Chemical Co., Ltd.), 2.4 parts by weight of glycidyl amine type epoxy resin (trade name Araldite MY721 manufactured by Ciba-Geygy Ltd.), and 41.1 parts by weight of a phenolic resin manufactured by Nippon Kayaku Co., Ltd. in a mixed solvents consisting of 4-butylolactone and n-methyl-2-pyrollidone.

Dispersed in the resultant solution by a kneading roll were 55.6 parts by weight of silica filler (trade name Adma fine SO-C2 manufactured by TATSUMORI LTD. average diameter 0.5 µm), 0.2 parts by weight of 2-ethyl-4-methyl imidazole, which is a curing catalyst manufactured by Tokyo Kasei Kogyo Co., Ltd., and 1.7 parts by weight of a silane coupling agent manufactured by Shin-Etsu Chemical Co., Ltd., followed by stirring and defoaming the dispersion so as to obtain an insulating resin composition for a multi-layered printed circuit wiring board.

Then, a printed circuit wiring board was manufactured as in Example 1 by using the insulating resin composition described above.

The sample thus prepared was tested and evaluated as in Example 7. Table 4 shows the results.

### Example 15:

In the first step, prepared was a solution by dissolving 100.0 parts by weight of terminal phenol group modified polyether sulfone as a thermoplastic resin (trade name Sumika Excel 5003P manufactured by Sumitomo Chemical Co., Ltd.), 131.7 parts by weight of polyfunctional epoxy resin as a first thermosetting resin (trade name TMH574 manufactured by Sumitomo Chemical Co., Ltd.), 33.1 parts by weight of bisphenol A type epoxy resin as a second thermosetting resin (trade name Epikote 828 manufactured by Yuka Shell Epoxy K.K.), and 68.6 parts by weight of triazine modified phenol novolak resin (trade name KA-7502L manufactured by DAINIPPON INK & CHEMICALS, INC.) in a mixed solvents consisting of 4-butylolactone and n-methyl-2-pyrollidone.

Dispersed in the resultant solution by a kneading roll were 83.4 parts by weight of silica filler (trade name Adma fine SO-C2 manufactured by TATSUMORI LTD. average diameter 0.5 µm), 0.3 parts by weight of 2-ethyl-4-methyl imidazole, which is a curing catalyst manufactured by Tokyo Kasei Kogyo Co., Ltd., and 2.5 parts by weight of a silane coupling agent manufactured by Shin-Etsu Chemical Co., Ltd., followed by stirring and defoaming the dispersion so as to obtain an insulating resin composition for a multi-layered printed circuit wiring board.

Then, a printed circuit wiring board was manufactured as in Example 1 by using the insulating resin composition described above.

The sample thus prepared was tested and evaluated as in Example 7. Table 4 shows the results.

### Comparative Example 6:

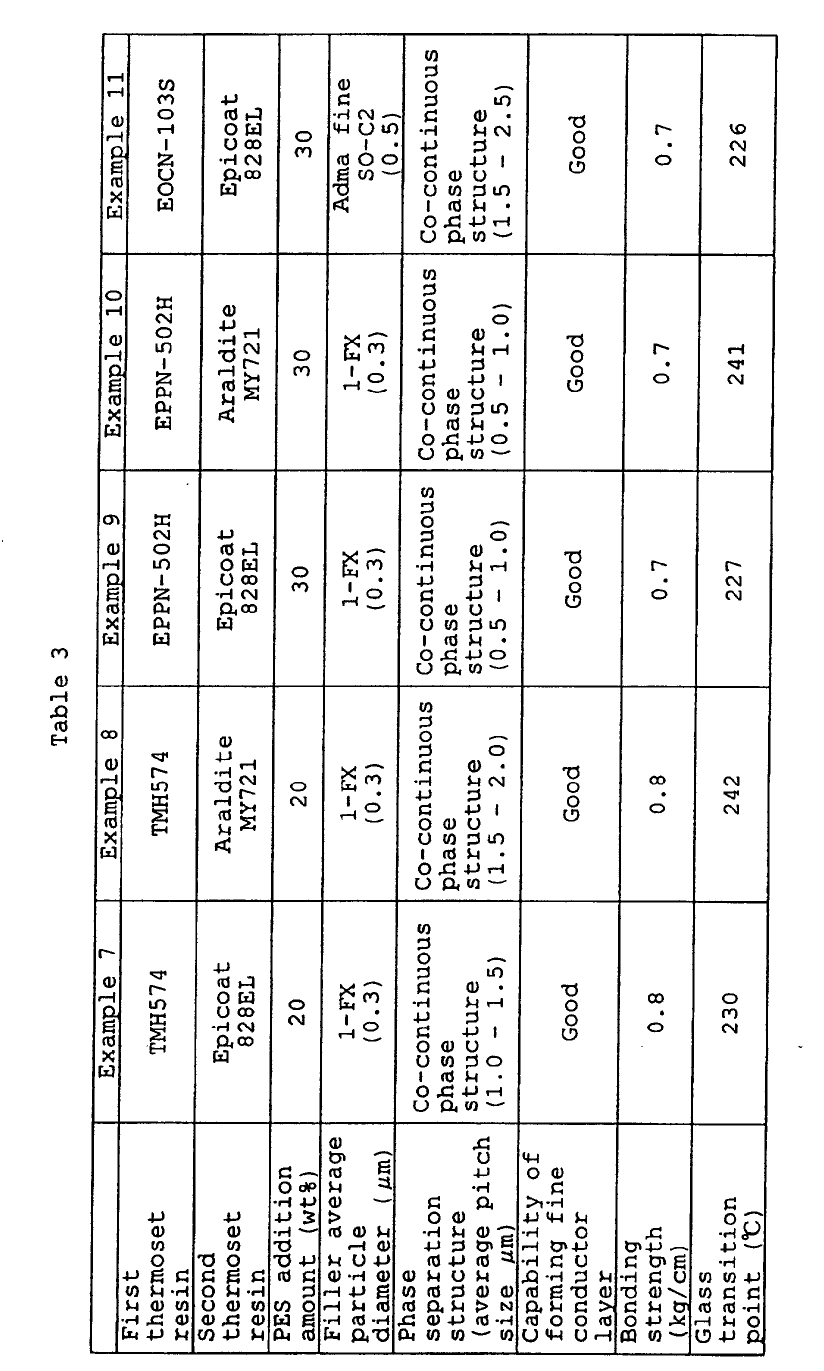

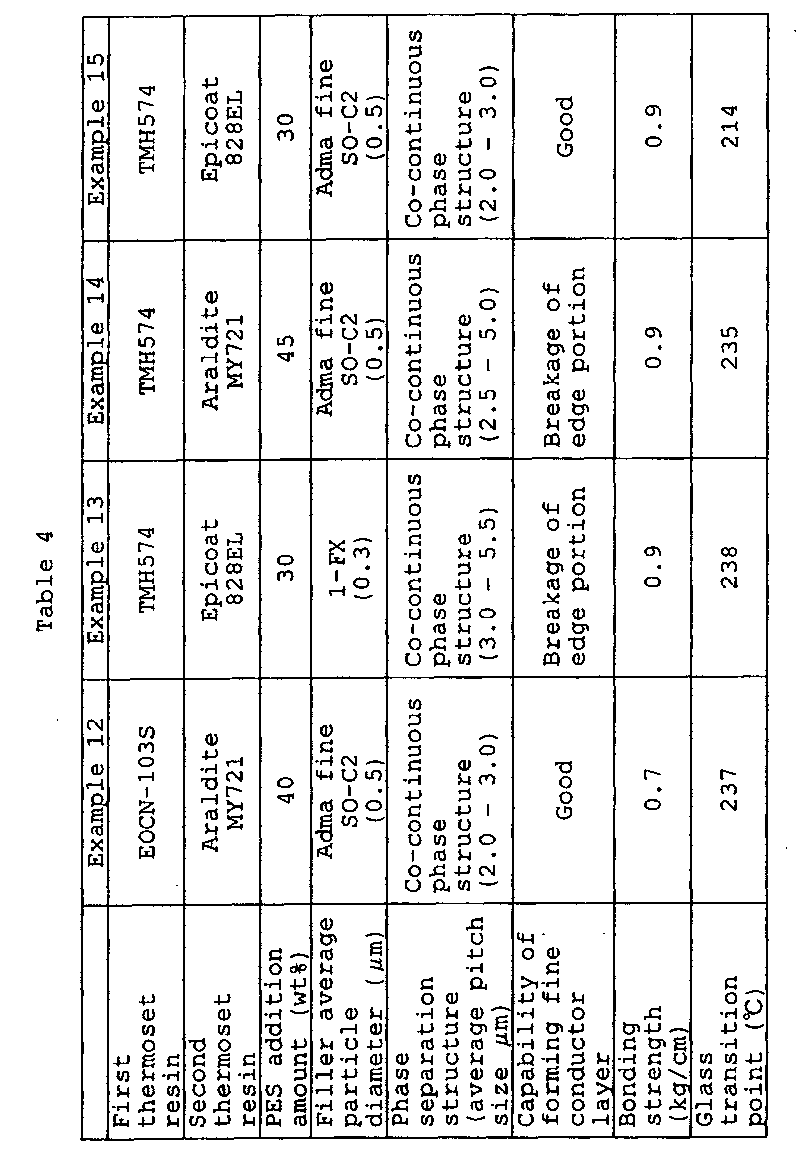

As apparent from Tables 3 and 4, in the case of using the insulating resin composition of the present invention, it is possible to form a printed circuit wiring board having, particularly, a smaller pitch size of the phase separation structure and having a high bonding strength.

Incidentally, it has been found that, if the weight ratio of the first thermosetting resin to the second thermosetting resin fails to fall within a range of between 95 : 5 and 50 : 50, the pitch size is somewhat increased and the bonding strength is somewhat lowered.

### Example 16:

In the first step, prepared was a solution by dissolving 100.0 parts by weight of terminal phenol group modified polyether sulfone as thermoplastic resin (trade name Sumika Excel 5003P manufactured by Sumitomo Chemical Co., Ltd.), 132.1 parts by weight of polyfunctional epoxy resin as a first thermosetting resin (trade name TMH574 manufactured by Sumitomo Chemical Co., Ltd.), 23.36 parts by weight of bisphenol A type epoxy resin as a second thermosetting resin (trade name Epikote 828 manufactured by Yuka Shell Epoxy Ltd.), and 77.8 parts by weight of a phenolic resin manufactured by Nippon Kayaku Co., Ltd. in a mixed solvents consisting of 4-butylolactone and n-methyl-2-pyrollidone.

Dispersed in the resultant solution by a kneading roll were 83.3 parts by weight of silica filler (trade name 1-FX manufactured by TATSUMORI LTD. average diameter 0.3 µm), 0.3 parts by weight of 2-ethyl-4-methyl imidazole, which is a curing catalyst manufactured by Tokyo Kasei Kogyo Co., Ltd., and 2.5 parts by weight of a silane coupling agent manufactured by Shin-Etsu Chemical Co., Ltd., followed by stirring and defoaming the dispersion so as to obtain a varnish containing the insulating resin composition of the present invention.

A PET film having a thickness of 35 µm was coated by a roll coater with the resultant varnish in a thickness of about 50 µm after the drying, followed by drying the coated varnish layer within a drying furnace at a drying temperature of 120°C so as to obtain a dry film laminated member constructed as shown in FIG. 7. In this case, the amount of the solvent remaining in the dry film was found to be about 15% by weight.

Then, prepared was a glass epoxy substrate having a copper wiring pattern formed thereon, which was constructed as shown in FIG. 9A and to which a blackening treatment and a haloless treatment were applied.

Further, dry film laminate members were laminated on the both sides of the glass epoxy substrate by using a pressurizing vacuum laminator. The satisfactory conditions which permit the resin composition to be loaded within the through-hole in a void-free state were found to include a temperature of 130°C, a pressure of 3 kgf/cm², a pressurizing time of 10 seconds, and a degree of vacuum not higher than 1 Torr. Then, the substrate was cooled to about room temperature, and the PET film was peeled off, followed by applying a thermal curing at 180°C for 2 hours so as to form a resin insulating layer on the glass epoxy substrate as shown in FIG. 9C.

Further, via holes were made by a UV/YAG laser in predetermined positions, as shown in FIG. 9D, followed by coarsening the surface of the resin insulating layer by the treatment with an alkali/permanganate solution so as to remove the smear from the bottoms of the via holes.

In the next step, an electroless plating was applied to the surface of the resin insulating layer so as to obtain an electroless plating metal layer. Further, an electroplating was applied with the resultant electroless plating metal layer used as an electrode so as to form a copper plating layer having a thickness of about 18 µm. Still further, the copper plating layer was patterned so as to manufacture a multi-layered printed circuit wiring board of the present invention. The printed circuit wiring board thus manufactured was tested and evaluated as follows.

Incidentally, the surface and the cross sectional structure of each of the insulating resin layers were observed with an SEM.

### Film Flexibility Test

A folding test by 180° was applied to the dry film laminated member so as to observe the crack occurrence, etc. in the dry film. The sample that did not exhibit any change in the outer appearance by the visual observation was evaluated as "good", and the sample in which cracks or film peeling took place was evaluated as "poor".

### Evaluation of Buried State of Via Hole and Conductive Circuit Pattern

The cross sectional shape of the multi-layered wiring board having the dry film laminated thereon was observed with an SEM. The sample in which the via holes or the clearance between the circuit patterns were loaded with the resin was evaluated as "good", and the sample in which the resin loading was unsatisfactory or cells were recognized was evaluated as "poor".

### Phase Separation Observation Test

The phase separation observation test was conducted as in Example 1.

### Bonding Strength Test

The bonding strength test was conducted as in Example 1.

### Reflow Reliability Test

Prepared was a multi-layered wiring board for evaluation having 7 kinds in area of square patterns formed thereon, each of said square patterns having a side falling within a range of between 4 mm and 25 mm. The multi-layered wiring board thus prepared was put in a reflow apparatus and heated at 240°C for 10 seconds so as to observe the swelling of the pattern.

The sample in which the swelling was not recognized at all in the heating treatment conducted 5 times was evaluated as "good". The sample in which the swelling was recognized in 1 or 2 patterns of the 7 patterns was evaluated as "partly poor". Further, the sample in which the swelling was recognized in almost all the patterns was evaluated as "poor".

### Thermal shock test

Prepared was a multi-layered wiring board that was designed such that, if cracks are generated, the inner layer circuit would be broken so as to bring about a poor conduction. The sample thus prepared was subjected to a cycle test of -65°C - R.T. - 150°C, each cycle being conducted for 15 minutes, and a good article ratio (n = 5) after 1000 cycles was determined by a tester.

The results of the tests and the evaluations are shown in Table 5.

### Example 17:

In the first step, prepared was a solution by dissolving 100.0 parts by weight of terminal phenol group modified polyether sulfone as a thermoplastic resin (trade name Sumika Excel 5003P manufactured by Sumitomo Chemical Co., Ltd.), 164.2 parts by weight of polyfunctional epoxy resin as a first thermosetting resin (trade name TMH574 manufactured by Sumitomo Chemical Co., Ltd.), 28.9 parts by weight of glycidyl amine type epoxy resin as a second thermosetting resin (trade name Araldite MY721 manufactured by Asahi Ciba Inc.), and 106.9 parts by weight of a phenolic resin manufactured by Nippon Kayaku Co., Ltd. in a mixed solvents consisting of 4-butylolactone and n-methyl-2-pyrollidone.

Dispersed in the resultant solution by a kneading roll were 100.0 parts by weight of silica filler (trade name 1-FX manufactured by TATSUMORI LTD. average diameter 0.3 µm), 0.4 parts by weight of 2-ethyl-4-methyl imidazole, which is a curing catalyst manufactured by Tokyo Kasei Kogyo Co., Ltd., and 3.0 parts by weight of a silane coupling agent manufactured by Shin-Etsu Chemical Co., Ltd., followed by stirring and defoaming the dispersion so as to obtain a varnish containing the insulating resin composition of the present invention.

Further, a printed circuit wiring board was prepared as in Example 16 by using the resin composition varnish described above and evaluated as in Example 16. Table 5 shows the results.

### Example 18:

In the first step, prepared was a solution by dissolving 100.0 parts by weight of terminal phenol group modified polyether sulfone as a thermoplastic resin (trade name Sumika Excel 5003P manufactured by Sumitomo Chemical Co., Ltd.), 166.5 parts by weight of polyfunctional epoxy resin as a first thermosetting resin (trade name EPPN-502H manufactured by Nippon Kayaku Co., Ltd.), 18.5 parts by weight of bisphenol A type epoxy resin as a second thermosetting resin (trade name Epikote 828EL manufactured by Yuka Shell Epoxy K.K.), and 115.0 parts by weight of a phenolic resin manufactured by Nippon Kayaku Co., Ltd. in a mixed solvents consisting of 4-butylolactone and n-methyl-2-pyrollidone.

Dispersed in the resultant solution by a kneading roll were 171.4 parts by weight of silica filler (trade name 1-FX manufactured by TATSUMORI LTD. average diameter 0.3 µm), 0.4 parts by weight of 2-ethyl-4-methyl imidazole, which is a curing catalyst manufactured by Tokyo Kasei Kogyo Co., Ltd., and 5.1 parts by weight of a silane coupling agent manufactured by Shin-Etsu Chemical Co., Ltd., followed by stirring and defoaming the dispersion so as to obtain a varnish containing the insulating resin composition of the present invention.

Further, a printed circuit wiring board was prepared as in Example 16 by using the resin composition varnish described above and evaluated as in Example 16. Table 5 shows the results.

### Example 19:

In the first step, prepared was a solution by dissolving 100.0 parts by weight of terminal phenol group modified polyether sulfone as a thermoplastic resin (trade name Sumika Excel 5003P manufactured by Sumitomo Chemical Co., Ltd.), 162.8 parts by weight of polyfunctional epoxy resin as a first thermosetting resin (trade name EPPN-502H manufactured by Nippon Kayaku Inc.), 18.3 parts by weight of glycidyl amine type epoxy resin as a second thermosetting resin (trade name Araldite MY721 manufactured by Asahi Ciba Inc.), and 118.9 parts by weight of a phenolic resin manufactured by Nippon Kayaku Co., Ltd. in a mixed solvents consisting of 4-butylolactone and n-methyl-2-pyrollidone.

Dispersed in the resultant solution by a kneading roll were 171.4 parts by weight of silica filler (trade name 1-FX manufactured by TATSUMORI LTD. average diameter 0.3 µm), 0.4 parts by weight of 2-ethyl-4-methyl imidazole, which is a curing catalyst manufactured by Tokyo Kasei Kogyo Co., Ltd., and 5.1 parts by weight of a silane coupling agent manufactured by Shin-Etsu Chemical Co., Ltd., followed by stirring and defoaming the dispersion so as to obtain a varnish containing the insulating resin composition of the present invention.

Further, a printed circuit wiring board was prepared as in Example 16 by using the resin composition varnish described above and evaluated as in Example 16. Table 5 shows the results.

### Example 20:

In the first step, prepared was a solution by dissolving 100.0 parts by weight of terminal phenol group modified polyether sulfone as a thermoplastic resin (trade name Sumika Excel 5003P manufactured by Sumitomo Chemical Co., Ltd.), 169.3 parts by weight of cresol novolak type epoxy resin as a first thermosetting resin (trade name EOCN-103S manufactured by Nippon Kayaku Co., Ltd., 30.0 parts by weight of bisphenol A type epoxy resin as a second thermosetting resin (trade name Epikote 828EL manufactured by Yuka Shell Epoxy K.K.), and 100.9 parts by weight of a phenolic resin manufactured by Nippon Kayaku Co., Ltd. in a mixed solvents consisting of 4-butylolactone and n-methyl-2-pyrollidone.

Dispersed in the resultant solution by a kneading roll were 171.6 parts by weight of silica filler (trade name Adma fine SO-C2 manufactured by TATSUMORI LTD. average diameter 0.5 µm), 0.4 parts by weight of 2-ethyl-4-methyl imidazole, which is a curing catalyst manufactured by Tokyo Kasei Kogyo Co., Ltd., and 5.1 parts by weight of a silane coupling agent manufactured by Shin-Etsu Chemical Co., Ltd., followed by stirring and defoaming the dispersion so as to obtain a varnish containing the insulating resin composition of the present invention.

Further, a printed circuit wiring board was prepared as in Example 16 by using the resin composition varnish described above and evaluated as in Example 16. Table 5 shows the results.

### Example 21:

In the first step, prepared was a solution by dissolving 10.0 parts by weight of terminal phenol group modified polyether sulfone as a thermoplastic resin (trade name Sumika Excel 5003P manufactured by Sumitomo Chemical Co., Ltd.), 114.3 parts by weight of polyfunctional epoxy resin as a first thermosetting resin (trade name TMH574 manufactured by Sumitomo Chemical Co., Ltd.), 12.7 parts by weight of bisphenol A type epoxy resin as a second thermosetting resin (trade name Epikote 828EL manufactured by Yuka Shell Epoxy K.K.), and 63.1 parts by weight of a phenolic resin manufactured by Nippon Kayaku Co., Ltd. in a mixed solvents consisting of 4-butylolactone and n-methyl-2-pyrollidone.

Dispersed in the resultant solution by a kneading roll were 85.7 parts by weight of silica filler (trade name 1-FX manufactured by TATSUMORI LTD.), 0.2 parts by weight of 2-ethyl-4-methyl imidazole, which is a curing catalyst manufactured by Tokyo Kasei Kogyo Co., Ltd., and 2.6 parts by weight of a silane coupling agent manufactured by Shin-Etsu Chemical Co., Ltd., followed by stirring and defoaming the dispersion so as to obtain a varnish containing the insulating resin composition of the present invention.

Further, a printed circuit wiring board was prepared as in Example 16 by using the resin composition varnish described above and evaluated as in Example 16. Table 6 shows the results.

### Example 22:

In the first step, prepared was a solution by dissolving 100.0 parts by weight of terminal phenol group modified polyether sulfone as a thermoplastic resin (trade name Sumika Excel 5003P manufactured by Sumitomo Chemical Co., Ltd.), 60.2 parts by weight of polyfunctional epoxy resin as a first thermosetting resin (trade name TMH574 manufactured by Sumitomo Chemical Co., Ltd.), 6.7 parts by weight of bisphenol A type epoxy resin as a second thermosetting resin (trade name Epikote 828EL manufactured by Yuka Shell Epoxy K.K.), and 33.3 parts by weight of a phenolic resin manufactured by Nippon Kayaku Co., Ltd. in a mixed solvents consisting of 4-butylolactone and n-methyl-2-pyrollidone.

Dispersed in the resultant solution by a kneading roll were 85.9 parts by weight of silica filler (trade name 1-FX manufactured by TATSUMORI LTD. average diameter 0.3 µm), 0.2 parts by weight of 2-ethyl-4-methyl imidazole, which is a curing catalyst manufactured by Tokyo Kasei Kogyo Co., Ltd., and 2.6 parts by weight of a silane coupling agent manufactured by Shin-Etsu Chemical Co., Ltd., followed by stirring and defoaming the dispersion so as to obtain a varnish containing the insulating resin composition of the present invention.

Further, a printed circuit wiring board was prepared as in Example 16 by using the resin composition varnish described above and evaluated as in Example 16. Table 6 shows the results.

### Example 23:

In the first step, prepared was a solution by dissolving 100.0 parts by weight of terminal phenol group modified polyether sulfone as a thermoplastic resin (trade name Sumika Excel 5003P manufactured by Sumitomo Chemical Co., Ltd.), 132.1 parts by weight of polyfunctional epoxy resin as a first thermosetting resin (trade name TMH574 manufactured by Sumitomo Chemical Co., Ltd.), 23.36 parts by weight of bisphenol A type epoxy resin as a second thermosetting resin (trade name Epikote 828EL manufactured by Yuka Shell Epoxy K.K.), and 77.8 parts by weight of a phenolic resin manufactured by Nippon Kayaku Co., Ltd. in a mixed solvents consisting of 4-butylolactone and n-methyl-2-pyrollidone.

Dispersed in the resultant solution by a kneading roll were 83.3 parts by weight of silica filler (trade name 1-FX manufactured by TATSUMORI LTD. average diameter 0.3 µm), 0.3 parts by weight of 2-ethyl-4-methyl imidazole, which is a curing catalyst manufactured by Tokyo Kasei Kogyo Co., Ltd., and 2.5 parts by weight of a silane coupling agent manufactured by Shin-Etsu Chemical Co., Ltd., followed by stirring and defoaming the dispersion so as to obtain a varnish containing the insulating resin composition of the present invention.

Then, a PET film having a thickness of 35 µm was coated by a roll coater with the resultant varnish in a thickness of about 50 µm after the drying, followed by drying the coated varnish layer within a drying furnace at a drying temperature of 100°C so as to obtain a dry film laminate body constructed as shown in FIG. 7. In this case, the amount of the solvent remaining in the dry film was found to be about 30% by weight.

Further, a printed circuit wiring board was prepared as in Example 14 by using the dry film laminate body thus prepared and evaluated as in Example 16. Table 6 shows the results.

### Example 24:

In the first step, prepared was a solution by dissolving 100.0 parts by weight of terminal phenol hydroxyl group modified polyether sulfone as a thermoplastic resin (trade name Sumika Excel 5003P manufactured by Sumitomo Chemical Co., Ltd.), 164.2 parts by weight of polyfunctional epoxy resin as a first thermosetting resin (trade name TMH574 manufactured by Sumitomo Chemical Co., Ltd.), 28.9 parts by weight of glycidyl amine type epoxy resin as a second thermosetting resin (trade name Araldite MY721 manufactured by Asahi Ciba Inc.), and 106.9 parts by weight of a phenolic resin manufactured by Nippon Kayaku Co., Ltd. in a mixed solvents consisting of 4-butylolactone and n-methyl-2-pyrollidone.

Dispersed in the resultant solution by a kneading roll were 100.0 parts by weight of silica filler (trade name 1-FX manufactured by TATSUMORI LTD. average diameter 0.3 µm), 0.4 parts by weight of 2-ethyl-4-methyl imidazole, which is a curing catalyst manufactured by Tokyo Kasei Kogyo Co., Ltd., and 3.0 parts by weight of a silane coupling agent manufactured by Shin-Etsu Chemical Co., Ltd., followed by stirring and defoaming the dispersion so as to obtain a varnish containing the insulating resin composition of the present invention.

Then, a PET film having a thickness of 35 µm was coated by a roll coater with the resultant varnish in a thickness of about 50 µm after the drying, followed by drying the coated varnish layer within a drying furnace at a drying temperature of 150°C so as to obtain a dry film laminate member constructed as shown in FIG. 7. In this case, the amount of the solvent remaining in the dry film was found to be about 1% by weight.

Further, a printed circuit wiring board was prepared as in Example 14 by using the dry film laminate member thus prepared and evaluated as in Example 16. Table 6 shows the results.

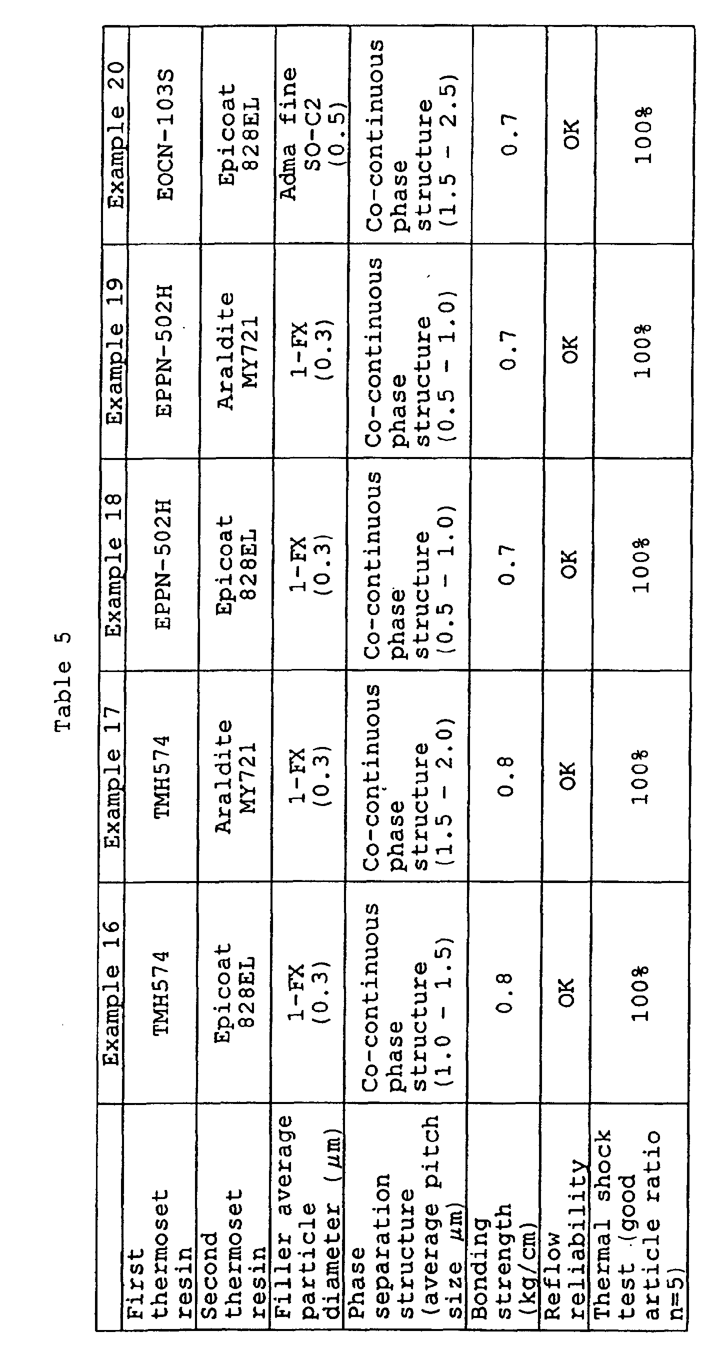

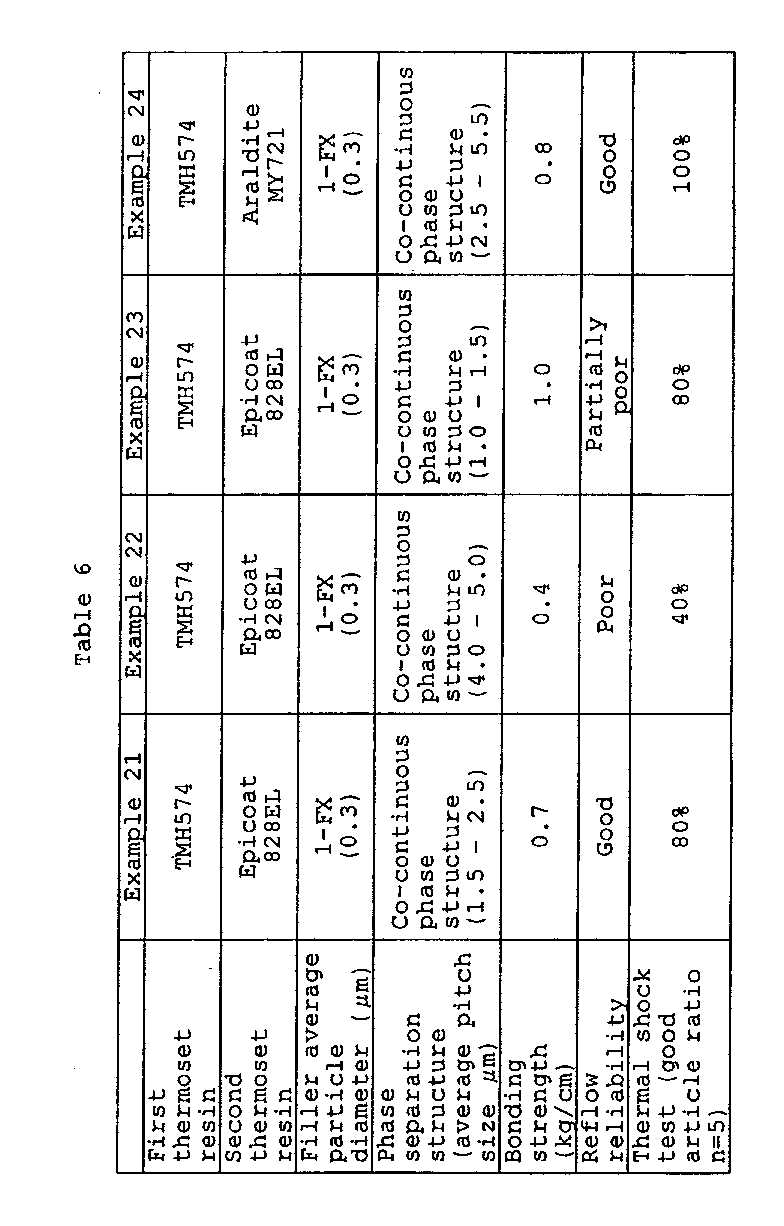

As apparent from Table 5, the experimental data for Examples 16 to 20 support that the present invention makes it possible to obtain a dry film transfer sheet for a multi-layered printed circuit wiring board excellent in its handling properties, in an inner-buried circuit, and in the burying properties in the pattern.

It should also be noted that, when it comes to the dry film transfer sheet of the present invention in, for example, Example 16, the content of the thermoplastic resin based on the total resin solid components was 30% by weight, making it possible to obtain a sufficient flexibility and satisfactory pattern burying properties. In Example 21, however, it has been found that the content of the thermoplastic resin was only 5% by weight, resulting in failure to obtain a sufficient flexibility. Further, the experimental data for Example 22 support that, where the content of the thermoplastic resin is 50% by weight, it is difficult to obtain sufficient pattern burying properties no matter how much the pressurizing force may be increased.

Further, the experimental data for Example 23 shown in Table 6 support that, if the amount of the solvent remaining in the film is increased to reach 30% by weight, the laminate adaptability is greatly affected by the tack on the film surface so as to tend to lower the pattern burying properties, and that the large amount of the solvent remaining the film tens to lower the reflow resistance. On the other hand, the experimental data for Example 24 support that, if the amount of the remaining solvent is lowered to 1% by weight, the flexibility of the film is lowered so as to tend to facilitate the crack occurrence and, thus, the dry film transfer sheet is rendered somewhat inferior in the handling properties.

The insulating resin composition of the present invention for a multi-layered printed circuit wiring board can be used for forming an insulating layer of a multi-layered printed circuit wiring board used in, for example, a semiconductor package.

The insulating resin composition of the present invention for a multi-layered printed circuit wiring board exhibits a high resistance to heat, has a high toughness, is small in thermal expansion coefficient, and is satisfactory in the bonding properties to a copper wiring, making it possible to form an insulating layer having a fine coarsened surface adapted for the formation of a fine pattern.

## Claims

1. An insulating resin composition for a multi-layered printed circuit wiring board, comprising:
i) a thermoplastic resin,
ii) a first thermosetting resin capable of forming a resin composite having a phase separated structure when a mixture of said first thermosetting resin and said thermoplastic resin is cured, and
iii) a filler,
wherein a cured resin of the insulating resin composition has a fine phase separated structure, and said filler is distributed in one of said thermosetting resin rich phase and said thermoplastic resin rich phase.

2. The insulating resin composition for a multi-layered printed circuit wiring board according to claim 1, further comprising (iv) a second thermosetting resin capable of forming a resin composite having a miscible structure when a mixture of said second thermosetting resin and said thermoplastic resin is cured.

3. The insulating resin composition for a multi-layered printed circuit wiring board according to claim 1, wherein said fine phase separated structure is one of the structure selected from the group consisting of a sea-island structure, a connected-globule structure, a composite dispersed phase structure and a co-continuous phase structure.

4. The insulating resin composition for a multi-layered printed circuit wiring board according to claim 3, wherein said fine phase separated structure is one of the structure selected from the group consisting of a sea-island structure, a connected-globule structure, and a composite dispersed phase structure, and said filler is distributed within the spherical domain of said structure.

5. The insulating resin composition for a multi-layered printed circuit wiring board according to claim 3, wherein said fine phase separated structure is a co-continuous phase structure, and said filler is distributed in the thermosetting resin rich phase.

6. The insulating resin composition for a multi-layered printed circuit wiring board according to claim 4, wherein said fine phase-separated structure has a pitch size of a periodic distance falling within a range of between 0.1 µm and 5 µm.

7. The insulating resin composition for a multi-layered printed circuit wiring board according to claim 2, wherein the cured material of the resin composition has a fine phase separated structure selected from the group consisting of a sea-island structure, a connected-globule structure, and a composite phase separated structure, and the said fine phase separated structure has a pitch size of a periodic distance falling within a range of between 0.1 µm and 3 µm.

8. The insulating resin composition for a multi-layered printed circuit wiring board according to claim 1, wherein said first thermosetting resin consists of an epoxy resin.

9. The insulating resin composition for a multi-layered printed circuit wiring board according to claim 2, wherein said first thermosetting resin and said second thermosetting resin consist of different epoxy resins.

10. The insulating resin composition for a multi-layered printed circuit wiring board according to claim 9, wherein the weight ratio of the epoxy resin constituting said first thermosetting resin to the epoxy resin constituting said second thermosetting resin falls within a range of between 95 : 5 and 50 : 50.

11. The insulating resin composition for a multi-layered printed circuit wiring board according to claim 8, wherein said first thermosetting resin consists of an epoxy resin represented by structural formula (1): 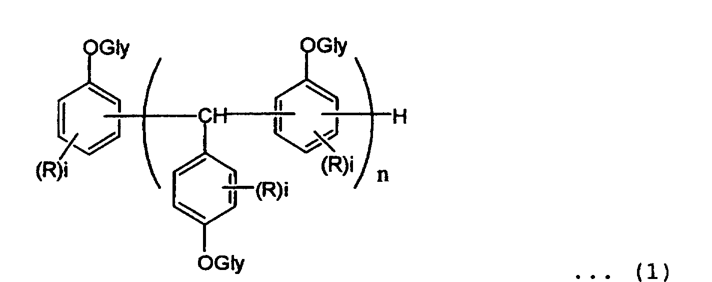 where n, which represents the number of average repetitions, is 1 to 10, R's, which may be the same or different, are independently a hydrogen atom, an alkyl group having 1 to 10 carbon atoms, a cycloalkyl group having 5 to 7 carbon atoms, or a hydrocarbon group having 6 to 20 carbon atoms and including a cycloalkyl group having 5 to 7 carbon atoms, i is independently an integer of 1 to 4, and Gly is a glycidyl group.

12. The insulating resin composition for a multi-layered printed circuit wiring board according to claim 9, wherein that said second thermosetting resin is at least one resin selected from the group consisting of a bisphenol A type epoxy resin, a bisphenol F type epoxy resin, a cresol novolak type epoxy resin, and a glycidyl amine type epoxy resin.

13. The insulating resin composition for a multi-layered printed circuit wiring board according to claim 8, further comprising an amino triazine modified phenol novolak resin as an epoxy curing agent.

14. The insulating resin composition for a multi-layered printed circuit wiring board according to claim 1, wherein said thermoplastic resin consists of polyether sulfone.

15. The insulating resin composition for a multi-layered printed circuit wiring board according to claim 14, wherein said polyether sulfone has a weight average molecular weight Mw falling within a range of between 1,000 and 100,000.

16. The insulating resin composition for a multi-layered printed circuit wiring board according to claim 1, wherein said first thermoplastic resin consists of a terminal phenol modified polyether sulfone.

17. The insulating resin composition for a multi-layered printed circuit wiring board according to claim 1, wherein said thermoplastic resin is contained in an amount of 10 to 40% by weight based on the total solid components of resins.

18. The insulating resin composition for a multi-layered printed circuit wiring board according to claim 1, wherein said filler is an inorganic filler.

19. The insulating resin composition for a multi-layered printed circuit wiring board according to claim 18, wherein said inorganic filler is silica.

20. The insulating resin composition for a multi-layered printed circuit wiring board according to claim 1, wherein said filler has an average particle diameter falling within a range of between 0.1 µm and 3 µm.

21. The insulating resin composition for a multi-layered printed circuit wiring board according to claim 1, wherein said filler is contained in an amount of 5 to 40% by weight based on the total solid components of the resin.

22. An insulating resin layer transfer sheet for a multi-layered printed circuit wiring board, comprising:
a sheet-like supporting member;
a dry film formed on said sheet-like supporting member and formed by using the insulating resin composition containing
i) a thermoplastic resin, ii) a first thermosetting resin capable of forming a resin composite having a phase separated structure when a mixture of said first thermosetting resin and said thermoplastic resin is cured, and iii) a filler,
wherein a cured resin of the insulating resin composition has a fine phase separated structure, and said filler is distributed in one of said thermosetting resin rich phase and said thermoplastic resin rich phase.

23. The insulating resin layer transfer sheet for a multi-layered printed circuit wiring board according to claim 22, further comprising (iv) a second thermosetting resin capable of forming a resin composite having a miscible structure when a mixture of said second thermosetting resin and said thermoplastic resin is cured.

24. The insulating resin layer transfer sheet for a multi-layered printed circuit wiring board according to claim 22, wherein said fine phase separated structure is one of the structure selected from the group consisting of a sea-island structure, a connected-globule structure, a composite dispersed phase structure and a co-continuous phase structure.

25. The insulating resin layer transfer sheet for a multi-layered printed circuit wiring board according to claim 24, wherein said fine phase separated structure is one of the structure selected from the group consisting of a sea-island structure, a connected-globule structure, and a composite dispersed phase structure, and said filler is distributed within the spherical domain of said structure.

26. The insulating resin layer transfer sheet for a multi-layered printed circuit wiring board according to claim 24, wherein said fine phase separated structure is a co-continuous phase structure, and said filler is distributed in the thermosetting resin rich phase.

27. The insulating resin layer transfer sheet for a multi-layered printed circuit wiring board according to claim 25, wherein said fine phase-separated structure has a pitch size of a periodic distance falling within a range of between 0.1 µm and 5 µm.

28. The insulating resin layer transfer sheet for a multi-layered printed circuit wiring board according to claim 23, wherein the cured material of the resin composition has a fine phase separated structure selected from the group consisting of a sea-island structure, a connected-globule structure, and a composite phase separated structure, and the said fine phase separated structure has a pitch size of a periodic distance falling within a range of between 0.1 µm and 3 µm.

29. The insulating resin layer transfer sheet for a multi-layered printed circuit wiring board according to claim 22, wherein said first thermosetting resin consists of an epoxy resin.

30. The insulating resin layer transfer sheet for a multi-layered printed circuit wiring board according to claim 23, wherein said first thermosetting resin and said second thermosetting resin consist of different epoxy resins.

31. The insulating resin layer transfer sheet for a multi-layered printed circuit wiring board according to claim 30, wherein the weight ratio of the epoxy resin constituting said first thermosetting resin to the epoxy resin constituting said second thermosetting resin falls within a range of between 95 : 5 and 50 : 50.

32. The insulating resin layer transfer sheet for a multi-layered printed circuit wiring board according to claim 29, wherein said first thermosetting resin consists of an epoxy resin represented by structural formula (1): 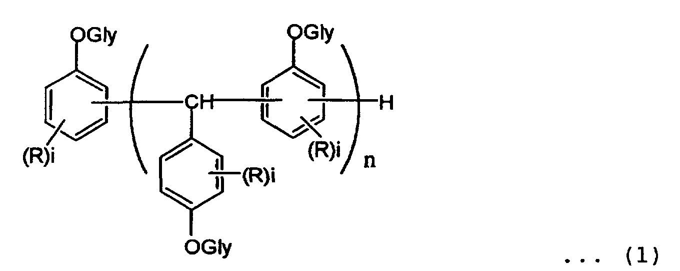 where n, which represents the number of average repetitions, is 1 to 10, R's, which may be the same or different, are independently a hydrogen atom, an alkyl group having 1 to 10 carbon atoms, a cycloalkyl group having 5 to 7 carbon atoms, or a hydrocarbon group having 6 to 20 carbon atoms and including a cycloalkyl group having 5 to 7 carbon atoms, i is independently an integer of 1 to 4, and Gly is a glycidyl group.

33. The insulating resin layer transfer sheet for a multi-layered printed circuit wiring board according to claim 30, wherein said second thermosetting resin is at least one resin selected from the group consisting of a bisphenol A type epoxy resin, a bisphenol F type epoxy resin, a cresol novolak type epoxy resin, and a glycidyl amine type epoxy resin.

34. The insulating resin layer transfer sheet for a multi-layered printed circuit wiring board according to claim 29, further comprising an amino triazine modified phenol novolak resin as an epoxy curing agent.

35. The insulating resin layer transfer sheet for a multi-layered printed circuit wiring board according to claim 22, wherein said thermoplastic resin consists of polyether sulfone.

36. The insulating resin layer transfer sheet for a multi-layered printed circuit wiring board according to claim 35, wherein said polyether sulfone has a weight average molecular weight Mw falling within a range of between 1,000 and 100,000.

37. The insulating resin layer transfer sheet for a multi-layered printed circuit wiring board according to claim 35, wherein said first thermoplastic resin consists of a terminal phenol modified polyether sulfone.

38. The insulating resin layer transfer sheet for a multi-layered printed circuit wiring board according to claim 22, wherein said thermoplastic resin is contained in an amount of 10 to 40% by weight based on the total solid components of resins.

39. The insulating resin layer transfer sheet for a multi-layered printed circuit wiring board according to claim 22, wherein said filler is an inorganic filler.

40. The insulating resin layer transfer sheet for a multi-layered printed circuit wiring board according to claim 39, wherein said inorganic filler is silica.

41. The insulating resin layer transfer sheet for a multi-layered printed circuit wiring board according to claim 22, wherein said filler has an average particle diameter falling within a range of between 0.1 µm and 3 µm.

42. The insulating resin layer transfer sheet for a multi-layered printed circuit wiring board according to claim 22, wherein said filler is contained in an amount of 5 to 40% by weight based on the total solid components of the resin.

43. A multi-layered printed circuit wiring board, comprising:
a substrate having a first wiring pattern;
an insulating layer formed on said substrate; and
a second wiring pattern formed on said insulating layer in a manner to be electrically connected to said first wiring pattern;
wherein said insulating layer consists essentially of a cured resin of the resin composition containing,
i) a thermoplastic resin, ii) a first thermosetting resin capable of forming a resin composite having a phase separated structure when a mixture of said first thermosetting resin and said thermoplastic resin is cured, and iii) a filler, and said cured resin of the insulating resin composition has a fine phase separated structure, said filler is distributed in one of said thermosetting resin rich phase and said thermoplastic resin rich phase, said cured resin has a fine phase separated structure, and said filler is distributed in only one of the thermosetting resin rich phase and the thermoplastic resin rich phase.

44. The multi-layered printed circuit wiring board according to claim 43, further comprising (iv) a second thermosetting resin capable of forming a resin composite having a miscible structure when a mixture of said second thermosetting resin and said thermoplastic resin is cured.

45. The multi-layered printed circuit wiring board according to claim 43, wherein said fine phase separated structure is one of the structure selected from the group consisting of a sea-island structure, a connected-globule structure, a composite dispersed phase structure and a co-continuous phase structure.

46. The multi-layered printed circuit wiring board according to claim 45, wherein said fine phase separated structure is one of the structure selected from the group consisting of a sea-island structure, a connected-globule structure, and a composite dispersed phase structure, and said filler is distributed within the spherical domain of said structure.

47. The multi-layered printed circuit wiring board according to claim 45, wherein said fine phase separated structure is a co-continuous phase structure, and said filler is distributed in the thermosetting resin rich phase.

48. The multi-layered printed circuit wiring board according to claim 46, wherein said fine phase-separated structure has a pitch size of a periodic distance falling within a range of between 0.1 µm and 5 µm.

49. The multi-layered printed circuit wiring board according to claim 44, wherein the cured material of the resin composition has a fine phase separated structure selected from the group consisting of a sea-island structure, a connected-globule structure, and a composite phase separated structure, and the said fine phase separated structure has a pitch size of a periodic distance falling within a range of between 0.1 µm. and 3 µm.

50. The multi-layered printed circuit wiring board according to claim 43, wherein said first thermosetting resin consists of an epoxy resin.

51. The multi-layered printed circuit wiring board according to claim 44, wherein said first thermosetting resin and said second thermosetting resin consist of different epoxy resins.

52. The multi-layered printed circuit wiring board according to claim 51, wherein the weight ratio of the epoxy resin constituting said first thermosetting resin to the epoxy resin constituting said second thermosetting resin falls within a range of between 95 : 5 and 50 : 50.

53. The multi-layered printed circuit wiring board according to claim 50, wherein said first thermosetting resin consists of an epoxy resin represented by structural formula (1): 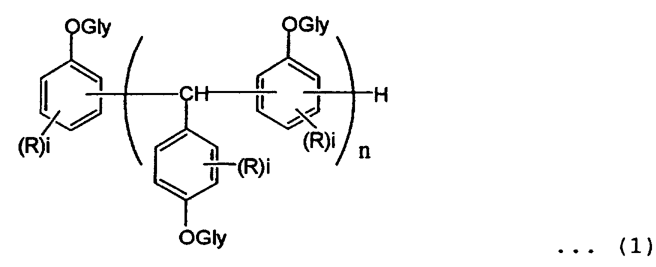 where n, which represents the number of average repetitions, is 1 to 10, R's, which may be the same or different, are independently a hydrogen atom, an alkyl group having 1 to 10 carbon atoms, a cycloalkyl group having 5 to 7 carbon atoms, or a hydrocarbon group having 6 to 20 carbon atoms and including a cycloalkyl group having 5 to 7 carbon atoms, i is independently an integer of 1 to 4, and Gly is a glycidyl group.

54. The multi-layered printed circuit wiring board according to claim 51, wherein said second thermosetting resin is at least one resin selected from the group consisting of a bisphenol A type epoxy resin, a bisphenol F type epoxy resin, a cresol novolak type epoxy resin, and a glycidyl amine type epoxy resin.

55. The multi-layered printed circuit wiring board according to claim 50, further comprising an amino triazine modified phenol novolak resin as an epoxy curing agent.

56. The multi-layered printed circuit wiring board according to claim 43, wherein said thermoplastic resin consists of polyether sulfone.

57. The multi-layered printed circuit wiring board according to claim 56, wherein said polyether sulfone has a weight average molecular weight Mw falling within a range of between 1,000 and 100,000.

58. The multi-layered printed circuit wiring board according to claim 56, wherein said first thermoplastic resin consists of a terminal phenol modified polyether sulfone.

59. The multi-layered printed circuit wiring board according to claim 43, wherein said thermoplastic resin is contained in an amount of 10 to 40% by weight based on the total solid components of resins.

60. The multi-layered printed circuit wiring board according to claim 43, wherein said filler is an inorganic filler.

61. The multi-layered printed circuit wiring board according to claim 60, wherein said inorganic filler is silica.

62. The multi-layered printed circuit wiring board according to claim 43, wherein said filler has an average particle diameter falling within a range of between 0.1 µm and 3 µm.

63. The multi-layered printed circuit wiring board according to claim 43, wherein said filler is contained in an amount of 5 to 40% by weight based on the total solid components of the resin.

64. A method of manufacturing a multi-layered printed circuit wiring board, comprising the steps of:
forming an insulating layer having a fine phase separated structure by coating a substrate having a first wiring pattern formed thereon with an insulating resin composition containing
i) a thermoplastic resin, ii) a first thermosetting resin capable of forming a resin composite having a phase separated structure when a mixture of said first thermosetting resin and said thermoplastic resin is cured, and iii) a filler,
wherein a cured resin of the insulating resin composition has a fine phase separated structure, and said filler is distributed in one of said thermosetting resin rich phase and said thermoplastic resin rich phase and subsequently thermally curing the coated layer of said insulating resin composition under a heated condition in which a phase separation takes place; and
forming a second wiring pattern on said insulating layer in a manner to be electrically connected to said first wiring pattern.

65. The method of manufacturing a multi-layered printed circuit wiring board according to claim 64, wherein said second wiring pattern is formed by an electroless plating and an electroplating.

66. The method of manufacturing a multi-layered printed circuit wiring board according to claim 64, **characterized in that** said heating conditions include a preheating step at 60 to 160°C for 30 minutes to 2 hours and a curing step at 160°C to 220°C for 30 minutes to 4 hours.

67. The method of manufacturing a multi-layered printed circuit wiring board according to claim 64, **characterized by** further comprising (iv) a second thermosetting resin capable of forming a resin composite having a miscible structure when a mixture of said second thermosetting resin and said thermoplastic resin is cured.

68. The method of manufacturing a multi-layered printed circuit wiring board according to claim 64, wherein said fine phase separated structure is one of the structure selected from the group consisting of a sea-island structure, a connected-globule structure, a composite dispersed phase structure and a co-continuous phase structure.

69. The method of manufacturing a multi-layered printed circuit wiring board according to claim 68, wherein said fine phase separated structure is one of the structure selected from the group consisting of a sea-island structure, a connected-globule structure, and a composite dispersed phase structure, and said filler is distributed within the spherical domain of said structure.

70. The method of manufacturing a multi-layered printed circuit wiring board according to claim 68, wherein said fine phase separated structure is a co-continuous phase structure, and said filler is distributed in the thermosetting resin rich phase.

71. The method of manufacturing a multi-layered printed circuit wiring board according to claim 69, wherein said fine phase-separated structure has a pitch size of a periodic distance falling within a range of between 0.1 µm and 5 µm.

72. The method of manufacturing a multi-layered printed circuit wiring board according to claim 67, wherein the cured material of the resin composition has a fine phase separated structure selected from the group consisting of a sea-island structure, a connected-globule structure, and a composite phase separated structure, and the said fine phase separated structure has a pitch size of a periodic distance falling within a range of between 0.1 µm and 3 µm.

73. The method of manufacturing a multi-layered printed circuit wiring board according to claim 64, wherein said first thermosetting resin consists of an epoxy resin.

74. The method of manufacturing a multi-layered printed circuit wiring board according to claim 67, wherein said first thermosetting resin and said second thermosetting resin consist of different epoxy resins.

75. The method of manufacturing a multi-layered printed circuit wiring board according to claim 74, wherein the weight ratio of the epoxy resin constituting said first thermosetting resin to the epoxy resin constituting said second thermosetting resin falls within a range of between 95 : 5 and 50 : 50.

76. The method of manufacturing a multi-layered printed circuit wiring board according to claim 73, wherein said first thermosetting resin consists of an epoxy resin represented by structural formula (1): 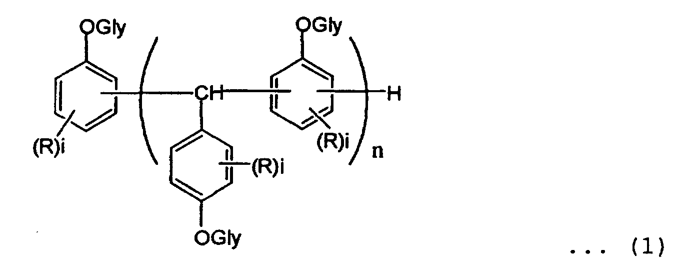 where n, which represents the number of average repetitions, is 1 to 10, R's, which may be the same or different, are independently a hydrogen atom, an alkyl group having 1 to 10 carbon atoms, a cycloalkyl group having 5 to 7 carbon atoms, or a hydrocarbon group having 6 to 20 carbon atoms and including a cycloalkyl group having 5 to 7 carbon atoms, i is independently an integer of 1 to 4, and Gly is a glycidyl group.

77. The method of manufacturing a multi-layered printed circuit wiring board according to claim 74, wherein said second thermosetting resin is at least one resin selected from the group consisting of a bisphenol A type epoxy resin, a bisphenol F type epoxy resin, a cresol novolak type epoxy resin, and a glycidyl amine type epoxy resin.

78. The method of manufacturing a multi-layered printed circuit wiring board according to claim 73, further comprising an amino triazine modified phenol novolak resin as an epoxy curing agent.

79. The method of manufacturing a multi-layered printed circuit wiring board according to claim 64, wherein said thermoplastic resin consists of polyether sulfone.

80. The method of manufacturing a multi-layered printed circuit wiring board according to claim 79, wherein said polyether sulfone has a weight average molecular weight Mw falling within a range of between 1,000 and 100,000.

81. The method of manufacturing a multi-layered printed circuit wiring board according to claim 64, wherein said first thermoplastic resin consists of a terminal phenol modified polyether sulfone.

82. The method of manufacturing a multi-layered printed circuit wiring board according to claim 64, wherein said thermoplastic resin is contained in an amount of 10 to 40% by weight based on the total solid components of resins.

83. The method of manufacturing a multi-layered printed circuit wiring board according to claim 64, wherein said filler is an inorganic filler.

84. The method of manufacturing a multi-layered printed circuit wiring board according to claim 83, wherein said inorganic filler is silica.

85. The method of manufacturing a multi-layered printed circuit wiring board according to claim 64, wherein said filler has an average particle diameter falling within a range of between 0.1 µm and 3 µm.

86. The method of manufacturing a multi-layered printed circuit wiring board according to claim 64, wherein said filler is contained in an amount of 5 to 40% by weight based on the total solid components of the resin.
